# EUROPEAN PATENT SPECIFICATION

(11) **EP 4 403 966 B1**
(45) Date of publication and mention of the grant of the patent: **21.10.2026**
(21) Application number: 22869898.1
(22) Date of filing: 08.09.2022
(51) Int. Cl.: G02B 5/20, C09K 11/06, F21V 9/30, F21Y 115/10, C09K 11/02, H05B 33/12

(54) **COLOR CONVERSION MEMBER, LIGHT SOURCE UNIT INCLUDING SAME, DISPLAY, AND ILLUMINATION DEVICE**
FARBUMWANDLUNGSELEMENT, LICHTQUELLENEINHEIT DAMIT, ANZEIGE UND BELEUCHTUNGSVORRICHTUNG
ÉLÉMENT DE CONVERSION DE COULEUR, UNITÉ DE SOURCE DE LUMIÈRE LE COMPRENANT, DISPOSITIF D'AFFICHAGE ET DISPOSITIF D'ÉCLAIRAGE

(30) Priority: 16.09.2021 JP 2021150930
(43) Date of publication of application: 24.07.2024
(73) Proprietor: Toray Industries, Inc., Tokyo 103-8666 (JP)
(72) Inventor: SAKAINO, Hirotoshi, Otsu-shi, Shiga 520-8558 (JP); KITAMURA, Manami, Otsu-shi, Shiga 520-8558 (JP); ICHIHASHI, Yasunori, Otsu-shi, Shiga 520-8558 (JP)
(74) Representative: Hoefer & Partner Patentanwälte mbB
(86) International application number: PCT/JP2022/033778
(87) International publication number: WO 2023/042751

(56) References cited:
- JP-A- 2005 077 553
- JP-A- 2016 062 804
- JP-A- 2016 062 804
- JP-A- 2018 004 928
- JP-A- 2018 004 928
- JP-A- 2018 194 684
- US-A1- 2021 134 890
- TORAY INDUSTRIES: "Translation of JP2018004928A -COLOR CONVERSION SHEET, AND LIGHT SOURCE UNIT, DISPLAY AND ILLUMINATION CONTAINING THE SAME", 1 July 2016 (2016-07-01), XP093305418, Retrieved from the Internet <URL:www.translate.google.com> [retrieved on 20250815]
- TSUCHIYA YOUICHI ET AL: "Exact Solution of Kinetic Analysis for Thermally Activated Delayed Fluorescence Materials", THE JOURNAL OF PHYSICAL CHEMISTRY A, vol. 125, no. 36, 2 September 2021 (2021-09-02), US, pages 8074 - 8089, XP093048406, ISSN: 1089-5639, DOI: 10.1021/acs.jpca.1c04056
- TSUCHIYA YOUICHI, DIESING STEFAN, BENCHEIKH FATIMA, WADA YOSHIMASA, DOS SANTOS PALOMA L., KAJI HIRONORI, ZYSMAN-COLMAN ELI, SAMUEL: "Exact Solution of Kinetic Analysis for Thermally Activated Delayed Fluorescence Materials", THE JOURNAL OF PHYSICAL CHEMISTRY A, WASHINGTON DC, US, vol. 125, no. 36, 16 September 2021 (2021-09-16), US , pages 8074 - 8089, XP093048406, ISSN: 1089-5639, DOI: 10.1021/acs.jpca.1c04056

## Description

### Technical Field

The present invention relates to a color conversion member, a light source unit containing the same, a display, and a lighting device.

### Background Art

Studies are vigorously conducted to apply full-color technology based on the color conversion technique to liquid crystal displays, organic EL displays, lighting devices, and the like. Color conversion represents the conversion of the light emitted by an illuminant into light of a longer wavelength, and the conversion of blue light to green light or red light is an example of color conversion.

A sheet formed of a composition having a color conversion function (hereinafter referred to as a color conversion composition) can be combined with, for example, a blue light source to convert the light from the blue light source into the three primary colors of blue, green, and red, that is, white light. Such a white light source formed by combining a blue light source and a sheet having a color conversion function (hereinafter referred to as a color conversion sheet) can be used as a light source unit such as a backlight unit, and the light source unit can be combined with a liquid crystal driver and a color filter to produce a full-color display. In addition, a white light source formed by combining a blue light source and a color conversion sheet can also be used directly as a white light source (lighting device) for LED lighting or the like.

Improving color reproducibility and durability has been a problem with liquid crystal displays based on the use of the color conversion technique. High color purity of blue, green, and red, achieved by reducing the half-width of the emission spectrum of a light source unit with respect to blue, green, and red light, is effective in improving color reproducibility. As a means of solving this problem, a technology using quantum dots made of inorganic semiconductor particles as a component of a color conversion composition has been proposed (see, for example, Patent Literature 1).

In addition, another technology is proposed, in which, in place of quantum dots, a luminescent material of an organic substance less prone to cause apprehension about a toxic element such as cadmium is used as a component of a color conversion composition. As an example of the technology using an organic luminescent material as a component of a color conversion composition, a color conversion material containing a pyrromethene compound has been disclosed (see, for example, Patent Literature 2 and 3). In addition, as a technology for enhancing the durability, a technology that uses an oxygen barrier to improve the durability has been proposed (see, for example, Patent Literature 4). Patent Literature 5 discloses a colour conversion member comprising a) a layer (A) comprising an organic luminescent material which emits fluorescence b) a layer (B) having an oxygen permeability of 0.8 cc/ (m2*day*atm).

### Citation List

### Patent Literature

Patent Literature 1: JP2012-22028A
Patent Literature 2: JP2010-61824A
Patent Literature 3: JP2014-136771A
Patent Literature 4: WO2017/057287
Patent Literature 5: JP2018-004928A

### Summary of Invention

### Technical Problem

Conventionally, the technology described in Patent Literature 4 can obtain a color conversion member that achieves excellent color reproducibility and excellent durability. In recent years, however, higher definition such as 4K or 8K, a high dynamic range (HDR), and higher contrast due to local dimming are accompanied by higher requirements for the illuminance of a light source unit of a liquid crystal display and higher requirements for the durability of a color conversion member. According to the technology described in the above-described Patent Literature 4, the durability is still insufficient.

An object of the present invention to be solved is to enhance both the color reproducibility and durability of a color conversion member usable for light source units such as backlight units, displays such as liquid crystal displays, and lighting devices such as LED lighting. In particular, an object of the present invention is to provide a color conversion member that achieves both high color-purity emission and high durability.

### Solution to Problem

That is, to solve the above-described problems, and achieve the object, a color conversion member according to the present invention is characterized by being a color conversion member that converts incident light into light of a wavelength different from the wavelength of the incident light, the color conversion member including at least the below-described (A) layer and (B) layer; wherein the (A) layer is a color conversion layer containing: at least one organic luminescent material that emits delayed fluorescence; and a binder resin; and wherein the (B) layer is a layer having an oxygen permeability of 1.0 cc/m²·day·atm or less.

### Advantageous Effects of Invention

A color conversion member according to the present invention achieves both high color-purity emission and high durability, and thus, achieves the effect of enhancing both the color reproducibility and durability.

### Brief Description of Drawings

Fig. 1 is a schematic cross-sectional view depicting the first example of a color conversion member according to an embodiment of the present invention.
Fig. 2 is a schematic cross-sectional view depicting the second example of a color conversion member according to an embodiment of the present invention.
Fig. 3 is a schematic cross-sectional view depicting the third example of a color conversion member according to an embodiment of the present invention.

### Description of Embodiments

Preferred embodiments of a color conversion member, a light source unit containing the same, a display, and a lighting device according to the present invention will be specifically described below. However, the present invention is not limited to the following embodiments, and various modifications may be made to practice the present invention depending on the purpose or intended use.

### <Color Conversion Member>

A color conversion member according to an embodiment of the present invention converts incident light from an illuminant such as a light source into light of a wavelength different from the wavelength of the incident light. In this context, the phrase "converts incident light into light of a wavelength different from the wavelength of the incident light" preferably means converting incident light into light of a wavelength longer than the wavelength of the incident light.

Hereinafter, the emission light observed to have a peak wavelength in the range of 500 nm or more and less than 580 nm is referred to as "green emission light", and the emission light observed to have a peak wavelength in the range of 580 nm or more and 750 nm or less is referred to as "red emission light".

A color conversion member according to an embodiment of the present invention is a layered member containing at least the below-described (A) layer and (B) layer. The (A) layer is a color conversion layer containing an organic luminescent material and a binder resin. The organic luminescent material contains at least one "organic luminescent material that emits delayed fluorescence" described below. The (B) layer is a layer having an oxygen permeability of 1.0 cc/m²·day·atm or less, that is, a layer having an oxygen barrier property. This color conversion member may contain one or more (A) layers, or may contain one or more (B) layers. In addition, the color conversion member may contain a plurality of (A) layers and a plurality of (B) layers. In this case, the (A) layers may be the same or different thereamong in terms of the composition and the form. The (B) layers may be the same or different thereamong in terms of the composition or the form.

Additionally, in a case where a color conversion member according to an embodiment of the present invention (hereinafter abbreviated as a color conversion member according to the present invention in some cases) contains the (A) layer as a color conversion layer and the (B) layer as an oxygen barrier layer, the layered structure of the layers can take any form of structure. Examples of representative structures of the color conversion member according to the present invention include the following three structures.

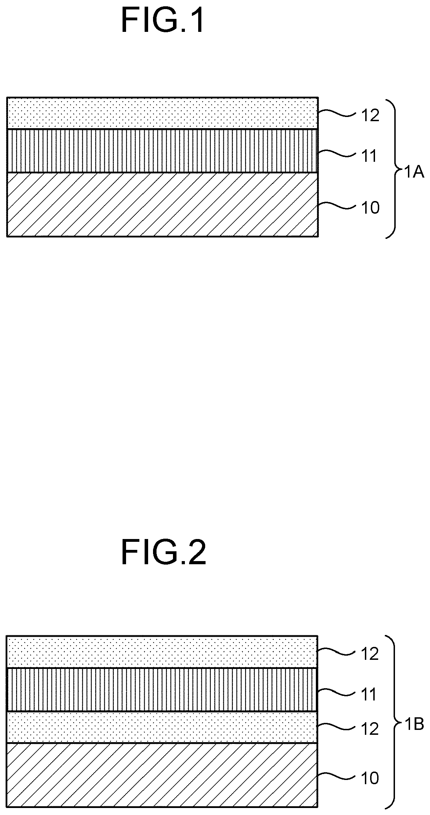

Fig. 1 is a schematic cross-sectional view depicting the first example of a color conversion member according to an embodiment of the present invention. As shown in Fig. 1, the color conversion member 1A in this first example includes a base material layer 10, an (A) layer 11, and a (B) layer 12, and forms a laminate of these layers. In this example of the structure of the color conversion member 1A, the (A) layer 11 is laminated on the base material layer 10, and the (B) layer 12 is laminated on this (A) layer 11.

Fig. 2 is a schematic cross-sectional view depicting the second example of a color conversion member according to an embodiment of the present invention. As shown in Fig. 2, the color conversion member 1B in this second example includes a base material layer 10, an (A) layer 11, and a plurality of (two in this embodiment) (B) layers 12, and forms a laminate with the (A) layer 11 sandwiched between the plurality of (B) layers 12. In this example of the structure of the color conversion member 1B, the (A) layer 11 and the (B) layers 12 are laminated in the order, the (B) layer/the (A) layer/the (B) layer, and the laminate of these (A) layer 11 and (B) layers 12 is formed on the base material layer 10. For example, the first (B) layer 12 is laminated on the base material layer 10, the (A) layer 11 is laminated on this (B) layer 12, and the second (B) layer 12 is laminated on this (A) layer 11.

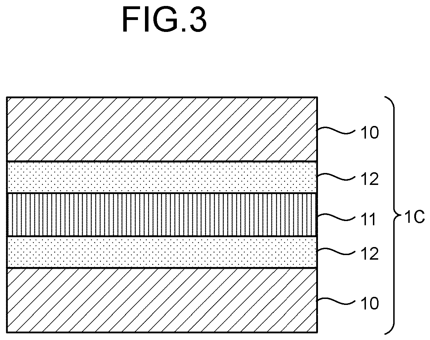

Fig. 3 is a schematic cross-sectional view depicting the third example of a color conversion member according to an embodiment of the present invention. As shown in Fig. 3, the color conversion member 1C in this third example includes a plurality of (two in this embodiment) base material layers 10, an (A) layer 11, and a plurality of (two in this embodiment) (B) layers 12. In this example of the structure of the color conversion member 1C, a laminate is formed in which the (A) layer 12 is sandwiched between these plurality of base material layers 10 and plurality of (B) layers 12. Specifically, the (A) layer 11 is sandwiched between the plurality of (B) layers 12, and the laminate composed of these (A) layer 11 and plurality of (B) layers 12 is further sandwiched between the plurality of base material layers 10. For example, as shown in Fig. 3, such a color conversion member 1C has a laminated structure in which the second base material layer 10 is laminated on the second (B) layer 12 in the color conversion member 1B in the above-described second example.

The above-described Figs. 1 to 3 illustrate the color conversion member 1A including one (A) layer 11 as a color conversion layer and one (B) layer 12 as an oxygen barrier layer, or illustrate the color conversion members 1B and 1C that each include a laminate composed of one (A) layer 11 sandwiched between two (B) layers 12. However, the layered structure of a color conversion member according to the present invention is not limited to these. For example, the layered structure of the (A) layer 11 and the (B) layer 12 in a color conversion member according to the present invention may be a structure in which the (A) layers 11 or the (B) layers 12 are consecutive in the direction of layers, such as the (B) layer/the (A) layer/the (A) layer, the (B) layer/the (B) layer/the (A) layer, or the (B) layer/the (B) layer/the (A) layer/the (A) layer. Further examples of the layered structure include a structure in which the (B) layer 12 covers the whole (A) layer 11 consecutively.

In this regard, the above-described structures of the color conversion member are examples, and a specific structure of a color conversion member according to the present invention is not limited to the above-described examples. In a case where the structure of the color conversion member is suitably modified in accordance with a matter derived from the below-described description, such a structure is also encompassed in the category of the present invention.

### <(A) Layer>

### (A-1. Organic Luminescent Material)

In the present invention, the (A) layer (for example, the (A) layer 11 depicted in Figs. 1 to 3) is a color conversion layer, and contains at least one organic luminescent material. Here, a luminescent material in the present invention refers to a material that, when irradiated with any light, emits light of a wavelength different from the wavelength of the former light.

To achieve high-efficiency color conversion, the luminescent material preferably exhibits luminescent characteristics for a high quantum yield. In general, examples of luminescent materials include known luminescent materials such as inorganic phosphors, fluorescent pigments, fluorescent dyes, and quantum dots. In the present invention, however, an organic luminescent material is preferably used as a luminescent material in the (A) layer from the viewpoints of the uniformity of dispersion, reductions in the amount of usage, and reductions in an environmental burden.

Among many organic luminescent materials, the (A) layer according to the present invention contains an organic luminescent material that emits delayed fluorescence. Here, an organic luminescent material that emits delayed fluorescence is explained on pages 87 to 103 in "State-of-the-Art Organic Light-Emitting Diodes" (Chihaya Adachi, Hiroshi Fujimoto, Eds; CMC Publishing Co., Ltd.). The literature explains that rendering the energy level of the singlet excited state of a luminescent material proximate to the energy level of the triplet excited state generates, with high efficiency, a reverse energy transfer from the triplet excited state, which usually has a low transition probability, to the singlet excited state, and develops thermally activated delayed fluorescence (TADF). Furthermore, in Fig. 5 in the literature, the mechanism of generation of delayed fluorescence is explained. The emission of delayed fluorescence can be verified by transient PL (Photo Luminescence) measurement.

In addition, it is reported *(*Nature Photonics, volume 14, pages 643-649 (2020)) that rendering the energy level of the singlet excited state of a luminescent material equal to the energy level of the triplet excited state can increase the rate of the reverse energy transfer from the triplet excited state to the singlet excited state. Furthermore, a compound is studied actively, in which the energy level of the triplet excited state of a luminescent material is higher than the energy level of the singlet excited state.

Herein, an organic luminescent material that transitions from the triplet excited state to the singlet excited state with high efficiency, and emits fluorescence is referred to as an "organic luminescent material that emits delayed fluorescence", encompassing an organic luminescent material that develops thermally activated delayed fluorescence. In addition, the "organic luminescent material that emits delayed fluorescence" is hereinafter abbreviated as a "delayed-fluorescence material" in some cases.

Usually, fluorescence is emitted from the singlet excited state generated after a luminescent material is photoexcited. The triplet excited state of the luminescent material, generated by intersystem crossing, is heat-inactivated, if in a roomtemperature environment. Because of this, fluorescence is not emitted from the triplet excited state of the luminescent material. On the other hand, as above-described, a delayed-fluorescence material is rapidly converted into the singlet excited state, and then emits fluorescence, even if the triplet excited state is generated. Accordingly, the triplet excited state, which is not capable of contributing to luminescence in a usual fluorescent material, can contribute to fluorescence. Thus, high-efficiency luminescence is obtained.

In addition, as below-described, the triplet excited state of an organic luminescent material can be a factor in deterioration of the organic luminescent material. However, a delayed-fluorescence material can rapidly convert the triplet excited state into the singlet excited state, and thus, can be expected to exhibit excellent durability. That is, to develop high durability, faster reverse intersystem crossing from the triplet excited state of a delayed-fluorescence material to the singlet excited state is better. For example, the rate constant of this reverse intersystem crossing is preferably 1.0 × 10² s⁻¹ or more.

In a molecular design in which the energy level of the singlet excited state is rendered proximate to the energy level of the triplet excited state, it is effective to bind an electron-donor skeleton to an electron-accepter skeleton in the same molecule. Thus, the HOMO (highest occupied molecular orbital) and the LUMO (lowest unoccupied molecular orbital) can be separated in the molecule. The electron-donor skeleton and the electron-accepter skeleton may be directly bound, or may be bound via a linking group. The linking group in this case has preferably a skeleton containing an aromatic hydrocarbon.

Examples of the electron-donor skeleton include a skeleton having an amine nitrogen atom. Among others, a skeleton containing diarylamine or triarylamine, a skeleton containing carbazole, a skeleton containing benzocarbazole, a skeleton containing indolocarbazole, a skeleton containing phenoxazine, and a skeleton containing phenothiazine are preferable. Among these, a skeleton containing carbazole, a skeleton containing benzocarbazole, a skeleton containing indolocarbazole, and a skeleton containing phenoxazine are more preferable. A skeleton containing carbazole and a skeleton containing phenoxazine are still more preferable.

On the other hand, examples of the electron-accepter skeleton usually include a skeleton containing an electron-attracting substituent (that is, an electron-attracting group). In organic electron theory, an electron-attracting group, also called an electron-accepting group, is an atomic group that attracts electrons by the inductive or resonance effect from another atomic group to which the electron-attracting group is substituted. Electron-attracting groups are substituents with a positive value for the Hammett substituent constant (σp (para)). The Hammett substituent constants (σp (para)) can be obtained from Handbook of Chemistry: Pure Chemistry, 5th Edition (p. II-380). In some cases, the phenyl group is positive for the Hammett substituent constant, but the electron-attracting group in the present invention includes no phenyl group.

Examples of the electron-attracting group include -F (σp: +0.20), -Cl (σp: +0.28), -Br (σp: +0.30), -I (σp: +0.30), -CO₂R¹² (σp: +0.45 for an ethyl group as R¹²), -CONH₂ (σp: +0.38), -COR¹² (σp: +0.49 for a methyl group as R¹²), -CF₃ (σp: +0.51), -SO₂R¹² (σp: +0.69 for a methyl group as R¹²), -NO₂ (σp: +0.81), and the like. R¹² independently represents a hydrogen atom, substituted or unsubstituted aromatic hydrocarbon group having 6 to 30 ring-forming carbon atoms, substituted or unsubstituted heterocycle having 5 to 30 ring-forming atoms, substituted or unsubstituted alkyl having 1 to 30 carbon atoms, or substituted or unsubstituted cycloalkyl having 1 to 30 carbon atoms. Specific examples of each of these groups include the same examples as of a substituent in a compound represented by the below-described general formula (2) or general formula (3).

Among the skeletons containing an electron-attracting group, a skeleton containing a heteroaryl group having a substructure in which a carbon atom and a nitrogen atom are bound via a double bond, a skeleton containing a fluorinated substituent, a skeleton containing a cyano group, a skeleton containing a carbonyl group, a skeleton containing a sulfoxide or a disulfoxide, a skeleton containing a phosphine oxide group, and the like are preferable. Among these, a skeleton containing a heteroaryl group having a substructure in which a carbon atom and a nitrogen atom are bound via a double bond, a skeleton containing a fluorinated substituent, and a skeleton containing a cyano group are more preferable from the viewpoint of the stability of a delayed-fluorescence material.

Among the skeletons containing a heteroaryl group having a substructure in which a carbon atom and a nitrogen atom are bound via a double bond, specifically a skeleton containing pyridine, pyrimidine, pyrazine, triazine, quinoline, quinoxaline, quinazoline, or phenanthroline is preferable. Among these, a skeleton containing pyrimidine, triazine, quinoxaline, or quinazoline is more preferable, and a skeleton containing triazine is still more preferable.

Among the skeletons containing a fluorinated substituent, a skeleton containing an aryl fluoride group or a fluoroalkyl group is more preferable. The skeleton containing an aryl fluoride group is preferably a fluorinated benzene ring, and specifically, more preferably a skeleton containing fluorobenzene, difluorobenzene, trifluorobenzene, tetrafluorobenzene, or pentafluorobenzene. The skeleton containing a fluoroalkyl group is preferably a skeleton containing a benzene ring substituted with a trifluoromethyl group, and among others, a skeleton containing mono(trifluoromethyl) benzene or bis(trifluoromethyl) benzene is more preferable.

Among the skeletons having a cyano group, a skeleton containing cyano benzene, dicyano benzene, or tricyano benzene is more preferable.

One example of the compound as described above having an electron-donor skeleton bound to an electron-accepter skeleton is described below, but the compound is not specifically limited to the example. In this regard, it is known according to past literature that the compounds described here emit delayed fluorescence.

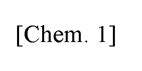

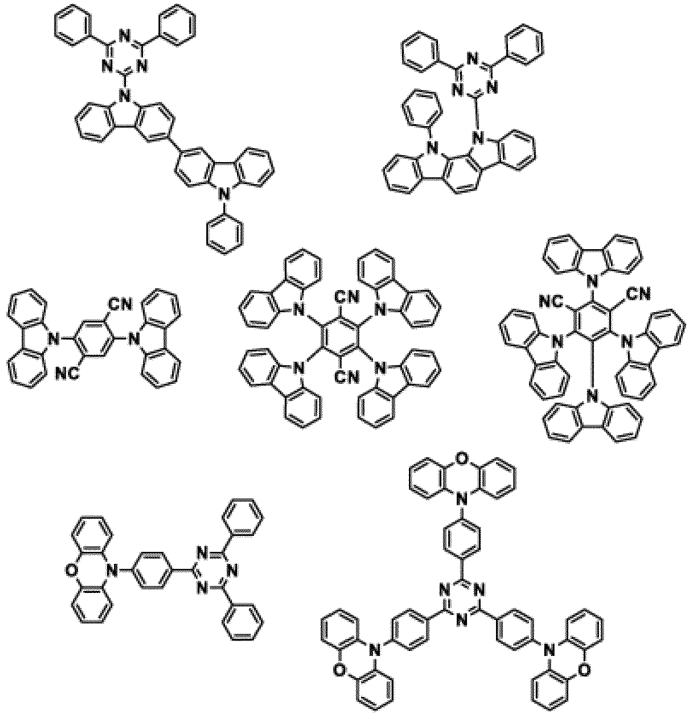

In addition, the delayed-fluorescence material is preferably a compound containing a substructure represented by the following general formula (1), other than the above-described compounds having an electron-donor skeleton bound to an electron-accepter skeleton.

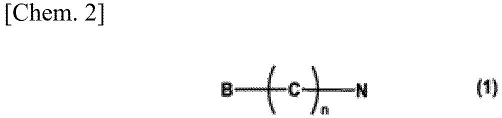

In the general formula (1), B is a boron atom, N is a nitrogen atom, and C is a carbon atom. n is an integer of 0 or larger and 2 or smaller. In a case where n is 0, a substructure represented by the general formula (1) represents a direct-bond structure between B and N.

In the delayed-fluorescence material containing a substructure represented by the general formula (1), an electron-donor nitrogen atom and an electron-accepter boron atom are located close to each other in the molecule. Such a delayed-fluorescence material is a compound in which the HOMO and the LUMO can be separated by the multiple-resonance effect. Clearly separating the HOMO and LUMO in a delayed-fluorescence material can render the energy level of the singlet excited state of the delayed-fluorescence material more proximate to the energy level of the triplet excited state, thus enabling delayed fluorescence to be emitted more easily. To render the energy level of the singlet excited state more proximate to the energy level of the triplet excited state, the delayed-fluorescence material is preferably a compound containing two or more substructures represented by the general formula (1) in the molecule.

In addition, in a delayed-fluorescence material, an extension of the π-conjugation system thereof allows reverse intersystem crossing from the triplet excited state to the singlet excited state to occur more efficiently. Accordingly, the π-conjugation system of a delayed-fluorescence material is preferably extended. From such a viewpoint, the delayed-fluorescence material preferably contains a compound represented by the below-described general formula (2) or general formula (3).

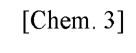

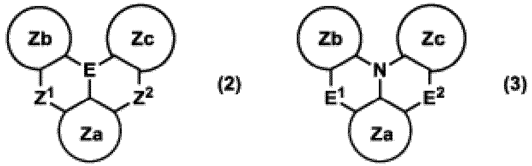

In the general formula (2) or the general formula (3), the ring Za, the ring Zb, and the ring Zc each independently represent a substituted or unsubstituted aryl ring having 6 to 30 ring-forming carbon atoms or a substituted or unsubstituted heteroaryl ring having 6 to 30 ring-forming carbon atoms.

In the general formula (2), Z¹ and Z² are each independently an oxygen atom, NRa (a nitrogen atom bearing an Ra substituent), or a sulfur atom. In a case where Z¹ is NRa, the substituent Ra, together with the ring Za or the ring Zb, optionally forms a ring. In a case where Z² is NRa, the substituent Ra, together with the ring Za or the ring Zc, optionally forms a ring. E is a boron atom, a phosphorus atom, SiRa (a silicon atom bearing an Ra substituent), or P=O.

In the general formula (3), E¹ and E² are independently BRa (a boron atom bearing an Ra substituent), PRa (a phosphorus atom bearing an Ra substituent), SiRa₂ (a silicon atom bearing two Ra substituents), P(=O)Ra₂ (a phosphine oxide bearing two Ra substituents) or P(=S)Ra₂ (a phosphine sulfide bearing two Ra substituents), or S(=O) or S(=O)₂. In a case where E¹ is BRa, PRa, SiRa₂, P(=O)Ra₂, or P(=S)Ra₂, the substituent Ra, together with the ring Za or the ring Zb, optionally forms a ring. In a case where E² is BRa, PRa, SiRa₂, P(=O)Ra₂, or P(=S)Ra₂, the substituent Ra, together with the ring Za or the ring Zc, optionally forms a ring.

The above-described substituents Ra are each independently a substituent selected from hydrogen, substituted or unsubstituted alkyl, substituted or unsubstituted cycloalkyl, substituted or unsubstituted heterocycle, substituted or unsubstituted alkenyl, substituted or unsubstituted cycloalkenyl, substituted or unsubstituted alkynyl, substituted or unsubstituted aryl, substituted or unsubstituted heteroaryl, hydroxyl, thiol, substituted or unsubstituted alkoxy, substituted or unsubstituted alkylthio, substituted or unsubstituted aryl ether, substituted or unsubstituted arylthioether, halogen, cyano, aldehyde, substituted or unsubstituted carbonyl, substituted or unsubstituted carboxyl, substituted or unsubstituted oxycarbonyl, substituted or unsubstituted ester, substituted or unsubstituted carbamoyl, substituted or unsubstituted amide, sulfonyl, substituted or unsubstituted sulfonic acid ester, substituted or unsubstituted sulfonamide, substituted or unsubstituted amino, substituted or unsubstituted imino, nitro, substituted or unsubstituted silyl, substituted or unsubstituted siloxanyl, substituted or unsubstituted boryl, substituted or unsubstituted phosphine oxide, and a condensed ring and an aliphatic ring that are each formed adjacently to a substituent. In addition, the substituent Ra may be further substituted with a substituent selected from these.

In addition, a compound represented by this general formula (2) or general formula (3) preferably contains, in the molecule, two or more substructures represented by the above-described general formula (1).

In all of the groups described above, hydrogen can be deuterium. This is also the case for the compounds or substructures thereof described in the following. For example, in the present DESCRIPTION, a substituted or unsubstituted C₆₋₄₀ aryl group refers to an aryl group whose number of carbon atoms is from 6 to 40, and includes the number of carbon atoms in the substituent attached to the aryl group. This is also true for other substituent groups with the specified number of carbon atoms.

The word "unsubstituted" in the phrase "substituted or unsubstituted" refers to substitution with a hydrogen atom or a deuterium atom. The phrase "substituted or unsubstituted" used in the context of the compounds or substructures thereof described below has the same meaning as described above.

**In** addition, in all of the above-described groups, a substituent in the case of substitution is alkyl, cycloalkyl, heterocycle, alkenyl, cycloalkenyl, alkynyl, aryl, heteroaryl, hydroxyl, thiol, alkoxy, alkylthio, arylether, arylthioether, halogen, cyano, aldehyde, carbonyl, carboxyl, oxycarbonyl, amide, sulfonyl, sulfonic acid ester, sulfonamide, amino, nitro, silyl, siloxanyl, boryl, or phosphine oxide. In addition, these substituents may be further substituted by any of the above-described substituents.

The alkyl group refers to a saturated aliphatic hydrocarbon group, such as methyl, ethyl, n-propyl, isopropyl, n-butyl, sec-butyl, or tert-butyl, and the alkyls may be substituted or unsubstituted. In a case where these hydrocarbon groups are substituted, the additional substituent is not specifically limited, and examples of the substituent include alkyl, halogen, aryl, and heteroaryl. The same is true throughout the following description. Furthermore, the number of carbon atoms in the alkyl groups is not specifically limited, but is preferably 1 or larger and 20 or smaller, more preferably 1 or larger and 8 or smaller, in view of availability and cost.

"Cycloalkyl" refers to a saturated alicyclic hydrocarbon group, such as cyclopropyl, cyclohexyl, norbornyl, or adamantyl, and the cycloalkyls may be substituted or unsubstituted. The number of carbon atoms in the alkyl groups is not specifically limited, but is preferably 3 or larger and 20 or smaller.

"Heterocycle" refers to an aliphatic ring having an atom other than carbon in the ring, such as pyran, piperidine, or cyclic amide, and the heterocycles may be substituted or unsubstituted. The number of carbon atoms in the heterocycle groups is not specifically limited, but is preferably 2 or larger and 20 or smaller.

"Alkenyl" refers to an unsaturated aliphatic hydrocarbon group containing a double bond, such as vinyl, allyl, or butadienyl, and the alkenyls may be substituted or unsubstituted. The number of carbon atoms in the alkenyl groups is not specifically limited, but is preferably 2 or larger and 20 or smaller.

"Cycloalkenyl" refers to an unsaturated alicyclic hydrocarbon group containing a double bond, such as cyclopentenyl, cyclopentadienyl, or cyclohexenyl, and the cycloalkenyls may be substituted or unsubstituted. The number of carbon atoms in the cycloalkenyl groups is not specifically limited, but is preferably 3 or larger and 20 or smaller.

"Alkynyl" refers to an unsaturated aliphatic hydrocarbon group containing a triple bond, such as ethynyl, and the alkynyls may be substituted or unsubstituted. The number of carbon atoms in the alkynyl groups is not specifically limited, but is preferably 2 or larger and 20 or smaller.

"Alkoxy" refers to a functional group containing an aliphatic hydrocarbon group connected via an ether linkage, such as methoxy, ethoxy, or propoxy, and the aliphatic hydrocarbon group may be substituted or unsubstituted. The number of carbon atoms in the alkoxy groups is not specifically limited, but is preferably 1 or larger and 20 or smaller.

"Alkylthio" refers to an alkoxy group in which the oxygen atom in the ether linkage is substituted with a sulfur atom. The hydrocarbon group in an alkylthio group may be substituted or unsubstituted. The number of carbon atoms in the alkylthio groups is not specifically limited, but is preferably 1 or larger and 20 or smaller.

"Arylether" refers to a functional group containing an aromatic hydrocarbon group connected via an ether linkage, such as phenoxy, and the aromatic hydrocarbon group may be substituted or unsubstituted. The number of carbon atoms in the arylether groups is not specifically limited, but is preferably 6 or larger and 40 or smaller.

"Arylthioether" refers to an arylether group in which the oxygen atom in the ether linkage is substituted with a sulfur atom. The aromatic hydrocarbon group in an arylthioether group may be substituted or unsubstituted. The number of carbon atoms in the arylthioether groups is not specifically limited, but is preferably 6 or larger and 40 or smaller.

"Aryl" refers to an aromatic hydrocarbon group, such as phenyl, biphenyl, terphenyl, naphthyl, fluorenyl, benzofluorenyl, dibenzofluorenyl, phenanthryl, anthracenyl, benzophenanthryl, benzoanthracenyl, chrysenyl, pyrenyl, fluoranthenyl, triphenylenyl, benzofluoranthenyl, dibenzoanthracenyl, perylenyl, or helicenyl. Among these, phenyl, biphenyl, terphenyl, naphthyl, fluorenyl, phenanthryl, anthracenyl, pyrenyl, fluoranthenyl, and triphenylenyl are preferred. The aryl groups may be substituted or unsubstituted. The number of carbon atoms in the aryl groups is not specifically limited but is preferably 6 or larger and 40 or smaller and more preferably 6 or larger and 30 or smaller.

In addition, the aryl is preferably phenyl, biphenyl, terphenyl, naphthyl, fluorenyl, phenanthryl, or anthracenyl, more preferably phenyl, biphenyl, terphenyl, or naphthyl. A phenyl group, a biphenyl group, or a terphenyl group is still more preferred, and a phenyl group is particularly preferred.

In a case where each substituent is further substituted with an aryl group, the aryl is preferably phenyl, biphenyl, terphenyl, naphthyl, fluorenyl, phenanthryl, or anthracenyl, more preferably phenyl, biphenyl, terphenyl, or naphthyl, and particularly preferably phenyl.

"Heteroaryl" refers to an aromatic ring group having one or more atoms other than carbon in the ring, such as pyridyl, furanyl, thienyl, quinolinyl, isoquinolinyl, pyrazinyl, pyrimidyl, pyridazinyl, triazinyl, naphthyridinyl, cinnolinyl, phthalazinyl, quinoxalinyl, quinazolinyl, benzofuranyl, benzothienyl, indolyl, dibenzofuranyl, dibenzothienyl, carbazolyl, benzo-carbazolyl, carbolinyl, indolo-carbazolyl, benzofuro-carbazolyl, benzothieno-carbazolyl, dihydroindeno-carbazolyl, benzoquinolinyl, acridinyl, dibenzoacridinyl, benzoimidazolyl, imidazopyridinyl, benzoxazolyl, benzothiazolyl, or phenanthrolinyl. However, naphthyridinyl refers to any of 1,5-naphthyridinyl, 1,6-naphthyridinyl, 1,7-naphthyridinyl, 1,8-naphthyridinyl, 2,6-naphthyridinyl, or 2,7-naphthyridinyl. The heteroaryl groups may be substituted or unsubstituted. The number of carbon atoms in the heteroaryl groups is not specifically limited, but is preferably 2 or larger and 40 or smaller, more preferably 2 or larger and 30 or smaller.

In addition, the heteroaryl group is preferably pyridyl, furanyl, thienyl, quinolinyl, pyrimidyl, triazinyl, benzofuranyl, benzothienyl, indolyl, dibenzofuranyl, dibenzothienyl, carbazolyl, benzoimidazolyl, imidazopyridinyl, benzoxazolyl, benzothiazolyl, or phenanthrolinyl, more preferably pyridyl, furanyl, thienyl, or quinolinyl, and particularly preferably pyridyl.

In a case where each substituent is further substituted with a heteroaryl group, the heteroaryl group is preferably pyridyl, furanyl, thienyl, quinolinyl, pyrimidyl, triazinyl, benzofuranyl, benzothienyl, indolyl, dibenzofuranyl, dibenzothienyl, carbazolyl, benzoimidazolyl, imidazopyridinyl, benzoxazolyl, benzothiazolyl, or phenanthrolinyl, more preferably pyridyl, furanyl, thienyl, or quinolinyl, and particularly preferably pyridyl.

"Halogen" refers to an atom selected from fluorine, chlorine, bromine, and iodine. Additionally, carbonyl, carboxyl, oxycarbonyl, and carbamoyl may be substituted or unsubstituted. In this respect, the substituent may be, for example, alkyl, cycloalkyl, aryl, or heteroaryl, and these substituents may be further substituted.

"Amino group" refers to a substituted or unsubstituted amino group. Examples of the substituent group in the case of substitution include aryl groups, heteroaryl groups, linear alkyl groups and branched alkyl groups. As the aryl group or the heteroaryl group, a phenyl group, a naphthyl group, a pyridyl group or a quinolinyl group is preferred. These substituents may be further substituted. The number of carbon atoms is not specifically limited, but is preferably 2 or larger and 50 or smaller, more preferably 6 or larger and 40 or smaller, and particularly preferably 6 or larger and 30 or smaller.

"Silyl group" refers to, for example, an alkylsilyl group, such as trimethylsilyl, triethylsilyl, tert-butyldimethylsilyl, propyldimethylsilyl, or vinyldimethylsilyl; or an arylsilyl group, such as phenyldimethylsilyl, *tert-*butyl(diphenyl)silyl, or triphenylsilyl, trinaphthylsilyl. The substituent on the silicon atom may be further substituted. The number of carbon atoms in the silyl groups is not specifically limited, but is preferably 1 or larger and 30 or smaller.

"Siloxanyl" refers to a group containing a silicon compound connected via an ether linkage, such as trimethylsiloxanyl. The substituent on the silicon atom may be further substituted. In addition, "boryl" refers to a substituted or unsubstituted boryl group. In a case where the boryl group is substituted, the substituent may be, for example, aryl, heteroaryl, linear alkyl, branched alkyl, aryl ether, alkoxy, or hydroxyl. Among these, aryl and arylether are preferred.

The phosphine oxide group is a group represented by -P(=O)R¹⁰R¹¹. R¹⁰R¹¹ in the phosphine oxide group are selected from the same group as of the above-described substituents in the case of substitution.

Examples of the substituted or unsubstituted aryl ring having 6 to 30 ring-forming carbon atoms in the ring Za, the ring Zb, and the ring Zc include aromatic hydrocarbon rings such as a benzene ring, naphthalene ring, phenanthrene ring, chrysene ring, anthracene ring, and pyrene ring. Among these, a benzene ring is preferable from the viewpoint of ensuring the solubility. In addition, examples of the heteroaryl ring having 6 to 30 ring-forming carbon atoms include an aromatic heteroaryl ring structure such as a pyridine ring, quinoline ring, and phenanthroline ring. Among these, a pyridine ring is preferable from the viewpoints of the availability of raw materials and the easiness of synthesis.

In the general formula (2), the substituent Ra is preferably a group having 6 to 40 carbon atoms, including a substituent. The substituent Ra is more preferably a substituted or unsubstituted aryl group. Examples of the substituted or unsubstituted aryl group include substituted or unsubstituted phenyl, substituted or unsubstituted biphenyl, substituted or unsubstituted fluorenyl, substituted or unsubstituted naphthyl, substituted or unsubstituted phenanthrenyl, and the like. Among these, a substituted or unsubstituted phenyl group is more preferable.

In addition, in the general formula (3), the substituent Ra is preferably a group having 6 to 40 carbon atoms, including a substituent. The substituent Ra is more preferably a substituted or unsubstituted aryl or a substituted or unsubstituted alkyl.

In the general formula (2), Z¹ and Z² are preferably an oxygen atom or NRa, because they efficiently extend the π-conjugation system of a compound represented by the general formula (2), resulting in more efficient reverse intersystem crossing from the triplet excited state to the singlet excited state, thus further increasing the durability.

In addition, E in the general formula (2) is preferably a boron atom, and E¹ and E² in the general formula (3) are preferably BRa, because they efficiently extend the π-conjugation system of the compound represented by the general formula (2) or the general formula (3), resulting in more efficient reverse intersystem crossing from the triplet excited state to the singlet excited state, thus further increasing the durability.

In addition, the ring Za, the ring Zb, and the ring Zc are preferably benzene rings, because they efficiently extend the π-conjugation system of the compound represented by the general formula (2) or the general formula (3), resulting in more efficient reverse intersystem crossing from the triplet excited state to the singlet excited state, thus further increasing the durability.

For example, as described in literature Adv. Mater., 2016, 28, 2777-2781, a compound represented by the general formula (2) or the general formula (3) is a molecule that can separate the HOMO and the LUMO by virtue of the multiple-resonance effect through having the optimal configuration of the electron-donor amine nitrogen atom and the electron-accepter boron atom. From the viewpoint of clearly separating the HOMO and the LUMO, and rendering the singlet excited state more proximate to the triplet excited state to make it easier to emit delayed fluorescence, it is preferable that, in the general formula (2), E is a boron atom having a strong electron-accepter property, and in addition, that both Z¹ and Z² are each NRa that is a group having a strong electron-donor property.

In addition, the emission spectrum of a compound represented by the general formula (2) or the general formula (3) is sharper, owing to the multiple-resonance effect of the compound, than a compound in which the electron-donor skeleton and the electron-accepter skeleton are bound. Accordingly, having, as a delayed-fluorescence material, a compound represented by the general formula (2) or the general formula (3) allows the emission of light having high color purity. That is, a compound represented by the general formula (2) or the general formula (3) is advantageous to enhance the color gamut of a display, and thus, is preferable as a delayed-fluorescence material. In addition, in a compound represented by the general formula (2) or the general formula (3), the ring Za, the ring Zb, and the ring Zc exist around the E atom in the general formula (2) or the general formula (3), in which E atom mainly the LUMO is localized. Thus, the LUMO can be delocalized from the E atom to each ring. Delocalizing the LUMO allows the multiple-resonance effect to work efficiently, thus allowing the emission of light having higher color purity. In this regard, the above-described E atom is the atom E in the general formula (2), and is each of the atoms E¹ and E² in the general formula (3).

Furthermore, it is more preferable that the substituent Ra in the general formula (2) or the general formula (3) is structurally bound to at least one of the ring Za, the ring Zb, or the ring Zc, because allowing the substituent Ra to be bound to at least one of the ring Za, the ring Zb, or the ring Zc more enhances the steric protection effect of E in the general formula (2) and of E¹ and E² in the general formula (3), thus making it possible to expect more enhancement of the effect of inhibiting a decrease in the fluorescent quantum yield.

Below, an example of a compound represented by the general formula (2) or the general formula (3) is shown. However, the compound is not limited thereto.

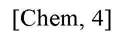

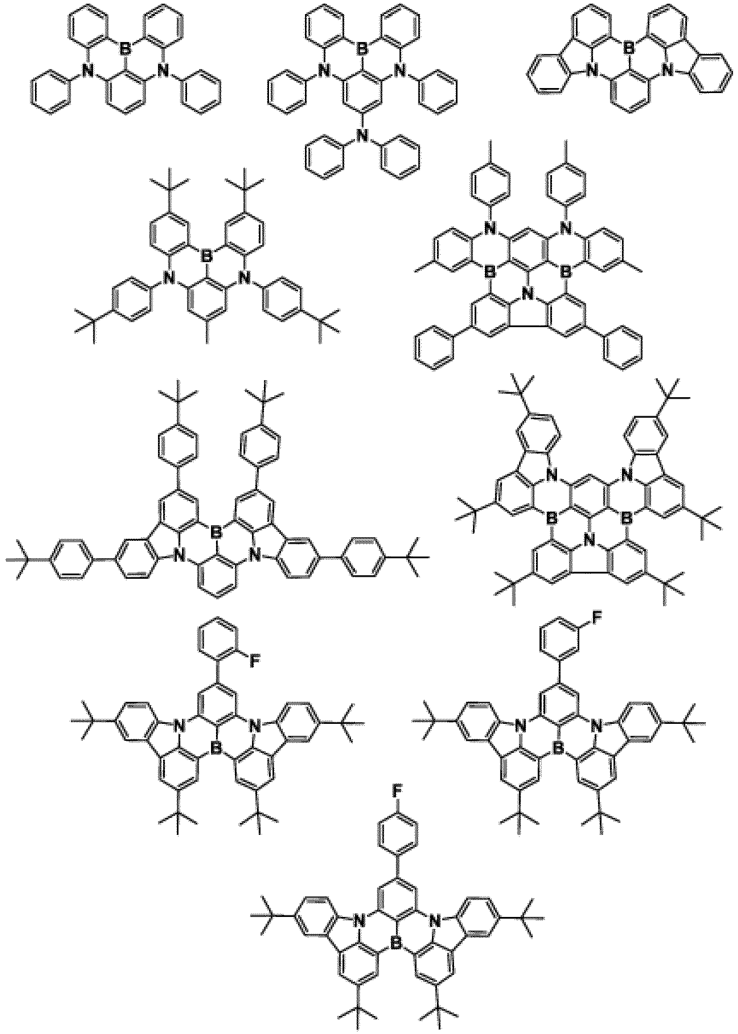

The emission wavelength of the delayed-fluorescence material is not specifically limited, and is preferably the emission wavelength of green or red light when the delayed-fluorescence material is excited by blue light to take out the three primary colors, blue, green, and red, from a blue light source. That is, it is preferable that the delayed-fluorescence material is observed to emit light having a peak wavelength in the region of 500 nm or more and less than 580 nm, when irradiated with excitation light having a wavelength in the range of 400 nm or more and 500 nm or less, or that the delayed-fluorescence material is observed to emit light having a peak wavelength in the region of 580 nm or more and 750 nm or less, when irradiated with excitation light having a wavelength in the range of 400 nm or more and 500 nm or less.

In addition, to expand the color gamut, and enhance the color reproducibility, the emission spectra of blue, green, and red colors are preferably less overlapped among one another.

For example, in a case where blue light having a wavelength in the range of 400 nm or more and 500 nm or less, and having a suitable excitation energy is used as excitation light, emission light observed to have a peak wavelength in the region of 500 nm or more is utilized as green emission light. This is preferable because the emission spectra of the excitation light and the green light are less overlapped, enhancing the color reproducibility. To make the effect even larger, the lower limit of the peak wavelength of light emitted when the delayed-fluorescence material emits green light is more preferably 510 nm or more, still more preferably 515 nm or more, particularly preferably 520 nm or more.

In addition, to decrease the overlap between the emission spectra of excitation light and red light, emission light observed to have a peak wavelength in the region of less than 580 nm is preferably utilized as green emission light. To make the effect even larger, the upper limit of the peak wavelength of light emitted when the delayed-fluorescence material emits green light is more preferably 550 nm or less, still more preferably 540 nm or less, particularly preferably 535 nm or less.

Furthermore, in a case where the emission light observed to have a peak wavelength in the range of 500 nm or more and less than 580 nm is used as green emission light, the emission light observed to have a peak wavelength in the range of 580 nm or more is used as red emission light. This is preferable because the emission spectra of the green light and the red light are less overlapped, enhancing the color reproducibility. To make the effect even larger, the lower limit of the peak wavelength of light emitted when the delayed-fluorescence material emits red light is more preferably 620 nm or more, still more preferably 630 nm or more, particularly preferably 635 nm or more.

The upper limit of the peak wavelength of red light needs only to be 750 nm or less that is at or around the upper bound of the visible range. **In** a case where the upper limit is 700 nm or less, such a wavelength provides larger visibility, and thus, is more preferable. To make the effect even larger, the upper limit of the peak wavelength observed when the delayed-fluorescence material emits red light is still more preferably 680 nm or less, particularly preferably 660 nm or less.

That is, in a case where blue light having a wavelength in the range of 400 nm or more and 500 nm or less is used as excitation light, the peak wavelength of green light is preferably 500 nm or more and less than 580 nm, more preferably 510 nm or more and 550 nm or less, still more preferably 515 nm or more and 540 nm or less, particularly preferably 520 nm or more and 530 nm or less. In addition, the peak wavelength of red light is preferably 580 nm or more and 750 nm or less, more preferably 620 nm or more and 700 nm or less, still more preferably 630 nm or more and 680 nm or less, particularly preferably 635 nm or more and 660 nm or less.

**In** addition, to decrease the overlap between the emission spectra, and enhance the color reproducibility, the half-width of the emission spectrum of each of the blue, green, and red colors is preferably smaller. In particular, the state in which the half-width of the emission spectrum of each of the green light and the red light is small is effective to enhance the color reproducibility.

For example, the half-width of the emission spectrum of the green light is preferably 50 nm or less, more preferably 40 nm or less, still more preferably 35 nm or less, particularly preferably 30 nm or less. The half-width of the emission spectrum of the red light is preferably 80 nm or less, more preferably 70 nm or less, still more preferably 60 nm or less, particularly preferably 50 nm or less.

In this regard, the shape of the emission spectrum of each of the blue, green, and red colors is not specifically limited. For example, the emission spectrum of each of these colors preferably has a single peak because such an emission spectrum makes it possible to utilize the excitation energy efficiently, and increase the color purity. Here, the single peak refers to a state in which, with respect to the peak having the strongest intensity in a wavelength region, no peak has an intensity not less than 5% of the strongest intensity.

In addition, in a case where the organic luminescent material emits green light, this organic luminescent material passes through an excited state having a higher energy than in a case where the material emits red light. Because of this, an organic luminescent material that emits green light (hereinafter abbreviated as a green luminescent material in some cases) essentially induces deterioration more easily than an organic luminescent material that emits red light. In contrast to this, an organic luminescent material that emits delayed fluorescence, particularly a delayed-fluorescence material containing a compound represented by the general formula (2) or the general formula (3), or the like can achieve both high-color-purity emission and high durability. Accordingly, to further enhance the durability of a color conversion member, at least a green luminescent material among the organic luminescent materials in the (A) layer is preferably an organic luminescent material that emits delayed fluorescence. That is, it is preferable that the delayed-fluorescence material is observed to emit light having a peak wavelength in the range of 500 nm or more and less than 580 nm, when irradiated with excitation light having a wavelength in the range of 400 nm or more and 500 nm or less.

### (A-2. Binder Resin)

In a color conversion member according to the present invention, the (A) layer further contains a binder resin in addition to at least one delayed-fluorescence material described above. The binder resin becomes the continuous phase and should be a material with excellent formability and processability, transparency, heat resistance, and the like. Examples of the binder resin include known binder resins, including photocurable resist materials containing reactive vinyl groups, such as acrylic, methacrylic, poly(vinyl cinnamate)-based, and cyclic rubber-based resists; and epoxy resins, silicone resins (including cured (cross-linked) organopolysiloxane materials such as silicone rubbers and silicone gels), urea resins, fluorocarbon resins, polycarbonate resins, acrylic resins, urethane resins, melamine resins, polyvinyl resins, polyamide resins, phenolic resins, polyvinyl alcohol resins, cellulose resins, aliphatic ester resins, aromatic ester resins, aliphatic polyolefin resins, and aromatic polyolefin resins. In addition, a copolymer resin of these monomers can be used as the binder resin. A binder resin useful for the (A) layer of a color conversion member according to the present invention can be obtained by appropriately designing these resins. Among these resins, thermoplastic resins are more preferable because of the easiness of a molding process such as sheet formation. Among thermoplastic resins, epoxy resins, silicone resins, acrylic resins, ester resins, olefin resins, or mixtures thereof are suitable for use from the viewpoint of transparency, heat resistance, and the like. In addition, acrylic resins, ester resins, and cycloolefin resins are particularly preferred thermoplastic resins from the viewpoint of durability.

Preferred examples of the binder resin include those described in, for example, WO2016/190283, WO2017/61337, WO2018/43237, WO2019/21813, and WO2019/188019.

In addition, the binder resin may be combined with additives such as a dispersing or leveling agent to stabilize the coating quality, while the binder resin may be combined with an adhesion promoter or the like, such as a silane coupling agent, as a sheet surface modifier. Furthermore, the binder resin can be combined with inorganic particles, such as silica or silicone particles, as a color conversion material anti-sedimentation agent.

In a color conversion composition for producing the above-described (A) layer, the binder resin is preferably combined with a hydrosilylation retardant such as acetylenic alcohol as an auxiliary component to extend pot life by preventing curing at normal temperature. Additionally, the binder resin may be combined with particles such as fumed silica, glass powder, or quartz powder; an inorganic filler or pigment such as titanium oxide, zirconium oxide, barium titanate, or zinc oxide; a flame retardant, a heat-resistant agent, an antioxidant, a dispersing agent, a solvent medium, an adhesion promoter such as a silane coupling agent or a titanium coupling agent, and the like, as required, provided that the effect of the invention is not impaired.

### (A-3. Other Luminescent Materials)

In the (A) layer in a color conversion member according to the present invention, a luminescent material (another luminescent material) other than an organic luminescent material that emits delayed fluorescence can be further used, besides the above-described delayed-fluorescence material. Examples of the another luminescent material include inorganic phosphors, fluorescent pigments, fluorescent dyes, quantum dots, and organic luminescent materials that emit no delayed fluorescence. The another luminescent material may contain two or more of these. To achieve high-efficiency color conversion, the another luminescent material is preferably a material that exhibits the luminescent characteristics for a high quantum yield. Specifically, a quantum dot and an organic luminescent material that emits no delayed fluorescence are preferable. Among these, an organic luminescent material that emits no delayed fluorescence is more preferable.

Suitable examples of the organic luminescent material that emits no delayed fluorescence include a compound having a condensed aryl ring, such as naphthalene, anthracene, phenanthrene, pyrene, chrysene, naphthacene, triphenylene, perylene, fluoranthene, fluorene, indene, a derivative thereof, and the like.

In addition, suitable examples of the organic luminescent material that emits no delayed fluorescence include a compound having a heteroaryl ring, such as furan, pyrrole, thiophene, silol, 9-silafluorene, 9,9'-spirobisilafluorene, benzothiophene, benzofuran, indole, dibenzothiophene, dibenzofuran, imidazopyridine, phenanthroline, pyridine, pyrazine, naphthyridin, quinoxaline, pyrrolopyridine, a derivative thereof, and the like.

In addition, suitable examples of the organic luminescent material that emits no delayed fluorescence include a borane derivative, stilbene derivative, aromatic acetylene derivative, tetraphenylbutadiene derivative, aldazine derivative, pyrromethene derivative, diketopyrrolo[3,4-c]pyrrole derivative, coumarin derivative, and the like. Examples of the stilbene derivative include 1,4-distyrylbenzene, 4,4'-bis(2-(4-diphenylaminophenyl)ethenyl)biphenyl, 4,4'-bis(N-(stilbene-4-yl)-N-phenylamino)stilbene, and the like. Examples of the coumarin derivative include coumarin 6, coumarin 7, coumarin 153, and the like.

In addition, suitable examples of the organic luminescent material that emits no delayed fluorescence include azole derivatives such as imidazole, thiazole, thiadiazole, carbazole, oxazole, oxadiazole, triazole, a metal complex thereof, and the like.

In addition, suitable examples of the organic luminescent material that emits no delayed fluorescence include a cyanine-based compound, xanthene-based compound, thioxanthene-based compound, and the like. Examples of the cyanine-based compound include indocyanine green and the like. Examples of the xanthene-based compound and the thioxanthene-based compound include fluorescein, eosin, rhodamine, and the like.

In addition, suitable examples of the organic luminescent material that emits no delayed fluorescence include a polyphenylene-based compound, naphthalimide derivative, phthalocyanine derivative and metal complex thereof, porphyrin derivative and metal complex thereof, oxazine-based compound, helicene-based compound, and the like. Examples of the oxazine-based compound include Nile red, Nile blue, and the like.

In addition, suitable examples of the organic luminescent material that emits no delayed fluorescence include an aromatic amine derivative, organometallic complex compound, and the like. Examples of the aromatic amine derivative include N,N'-diphenyl-N,N'-di(3-methylphenyl)-4,4'-diphenyl-1,1'-diamine, and the like. Examples of the organometallic complex compound include iridium (Ir), ruthenium (Ru), rhodium (Rh), palladium (Pd), platinum (Pt), osmium (Os), rhenium (Re), and the like.

The above-described organic luminescent material that emits no delayed fluorescence may be a fluorescent material or a phosphorescent material, and is preferably a fluorescent material, to achieve high color purity. Among these, a pyrromethene derivative can be suitably used from the viewpoints of providing a high fluorescent quantum yield, and having chromaticity the durability of which is better. Among the pyrromethene derivatives, a boron complex of pyrromethene is preferable.

In addition, in a color conversion member according to the present invention, the (A) layer may further contain an assist dopant such as rubrene to enhance the efficiency of energy transfer from excitation light to a delayed-fluorescence material.

### (A-4. Other Components)

In a color conversion member according to the present invention, the (A) layer may include, in addition to the above-described delayed-fluorescence material and binder resin, another component (additive) such as a photostabilizer, an antioxidant, a process/heat stabilizer, a light-resistant stabilizer such as an ultraviolet absorber, scattering particles, silicone particles, or a silane coupling agent.

Examples of the photostabilizer include, but are not specifically limited to, tertiary amines, catechol derivatives, nickel compounds, and complexes and organic acid salts containing at least one transition metal selected from the group consisting of Sc, V, Mn, Fe, Co, Cu, Y, Zr, Mo, Ag, and lanthanoids. In addition, the photostabilizers may be used individually or in combination.

Examples of the antioxidant include, but are not specifically limited to, phenolic antioxidants such as 2,6-di-tert-butyl p-cresol and 2,6-di-tert-butyl-4-ethylphenol. In addition, these antioxidants may be used individually or in combination.

Examples of the process/heat stabilizer include, but are not specifically limited to, phosphoric stabilizers, such as tributyl phosphite, tricyclohexyl phosphite, triethylphosphine, and diphenylbutylphosphine. In addition, these stabilizers may be used individually or in combination.

Examples of the light-resistant stabilizer include, but are not specifically limited to, benzotriazoles, such as 2-(5-methyl-2-hydroxyphenyl)benzotriazole and 2-[2-hydroxy-3,5-bis(α,α-dimethylbenzyl)phenyl]-2H-benzotriazole. In addition, these light-resistant stabilizers may be used individually or in combination.

The scattering particles are preferably, for example, inorganic particles having a refractive index of 1.7 or more and 2.8 or less. Examples of the inorganic particles include titania, zirconia, alumina, ceria, tin oxide, indium oxide, iron oxide, zinc oxide, aluminum nitride, sulfides of aluminum, tin, titanium, or zirconium, and hydroxides of titanium or zirconium.

Preferably, the contents of these additives in the (A) layer may vary depending on the molar absorption coefficients, luminescence quantum yields, and absorption intensities at the excitation wavelengths of the compounds, and the thickness and transmittance of the (A) layer produced and are typically 1.0 × 10⁻³ part by weight or more and 30 parts by weight or less relative to 100 parts by weight of the binder resin. Furthermore, the contents of these additives are more preferably 1.0 × 10⁻² part by weight or more and 15 parts by weight or less, particularly preferably 1.0 × 10⁻¹ part by weight or more and 10 parts by weight or less, relative to 100 parts by weight of the binder resin.

In addition, the amount of the remaining solvent in the (A) layer that has been dried is preferably 3.0% by weight or less, more preferably 1.0% by weight or less, still more preferably 0.5% by weight or less, from the viewpoint of more enhancing the durability of the luminescent material. In addition, the amount of the remaining solvent is preferably 0.01% by weight or more, more preferably 0.05% by weight or more, still more preferably 0.1% by weight or more, from the viewpoint of enhancing the quantum yield of the luminescent material.

In addition, the thickness of the (A) layer is not specifically limited, and is preferably 5 µm or more and 1000 µm or less. The lower limit of the thickness of the (A) layer is more preferably 10 µm or more. In addition, the upper limit of the thickness of the (A) layer is more preferably 200 µm or less, still more preferably 100 µm or less, particularly preferably 50 µm or less. In the present invention, the thickness of the (A) layer refers to a film thickness (an average film thickness) measured by the thickness measurement method A based on mechanical scanning in JIS K7130 (1999) "Plastics - Film and sheeting - Determination of thickness". In addition, the (A) layer may be a layer composed of one color conversion layer, or may be a laminate obtained by laminating two or more color conversion layers.

### <(B) Layer>

The (B) layer is a layer (oxygen barrier layer) having an oxygen barrier property. The oxygen barrier property refers to a characteristic for a low oxygen permeability. In the present invention, the oxygen permeability of the (B) layer is 1.0 cc/m²·day·atm or less. The oxygen permeability of this (B) layer is preferably 0.5 cc/m²·day·atm or less, more preferably 0.1 cc/m²·day·atm or less.

In this regard, the oxygen permeability is a value measured on the basis of a coulometric sensor method described in JIS K7126-2 (2006), using an oxygen permeation analyzer (model name, "OXTRAN" (registered trademark) 2/20) manufactured by Mocon (the U.S.A.), and using a planar test piece having a uniform film thickness, under conditions of a temperature of 20°C and a humidity of 0% RH, unless otherwise specified.

The (B) layer may be provided at any position of the color conversion member as long as the (B) layer can inhibit oxygen permeation into the above-described (A) layer (color conversion layer). From the viewpoint of inhibiting the oxygen permeation into the (A) layer more reliably, the (B) layer is preferably provided on at least one of both faces of the (A) layer in the thickness direction, for example, as the (B) layer 12 depicted in Fig. 1 is. In particular, it is more preferable that the (B) layer is layered in the order, the (B) layer/the (A) layer/the (B) layer, that is, provided on both faces of the (A) layer in the thickness direction, for example, as the (B) layers 12 depicted in Figs. 2 and 3 are.

In a color conversion member according to the present invention, the (B) layer may be in direct contact with the (A) layer, or another layer may mediate between the (A) layer and the (B) layer. From the viewpoint of inhibiting the oxygen permeation into the (A) layer, it is preferable that the (B) layer is in direct contact with the (A) layer, or that the (B) layer and the (A) layer are laminated with the below-described adhesive layer alone therebetween.

In addition, the (B) layer is preferably transparent so as not to impede the luminescent characteristics of the (A) layer. Here, being transparent means that the absorption and scattering in the visible range are small, and specifically means that the total light transmittance is 80% or more. The total light transmittance of the (B) layer is more preferably 85% or more, particularly preferably 90% or more.

In addition, it is also preferable that the haze of the (B) layer is 7% or less. The haze of the (B) layer is more preferably 5% or more, still more preferably 2% or more, particularly preferably 1% or less.

In this regard, the total light transmittance and the haze are each a value measured in accordance with JIS K7361 (1997), using a haze meter NDH2000 manufactured by Nippon Denshoku Industries Co., Ltd., and using a planar test piece having a uniform film thickness, under conditions of a temperature of 23°C and a humidity of 50% RH.

In a color conversion member according to the present invention, the (B) layer is provided for the purpose of more enhancing the durability of a delayed-fluorescence material contained in the (A) layer.

In general, when an organic luminescent material is excited in the presence of oxygen, energy transfer (generally called dye sensitization) occurs between the organic luminescent material in the triplet excited state and triplet oxygen in the ground state, generating singlet oxygen. It is known that this singlet oxygen generated has a strong oxidative power, and thus, induces deterioration due to the oxidation of the luminescent material.

As above-described, the delayed-fluorescence material has a property by which the triplet excited state is converted into the singlet excited state rapidly. However, the ratio at which the delayed-fluorescence material in the triplet excited state is generated is relatively large. Thus, when oxygen is present in the (A) layer, the action of dye sensitization causes singlet oxygen to be generated, whereby the luminescent material (delayed-fluorescence material or the like) in the (A) layer is oxidated and deteriorated.

On the other hand, under conditions where no oxygen is present, a delayed-fluorescence material exhibits very excellent durability, compared with another luminescent material, such as an organic luminescent material that emits no delayed fluorescence.

For example, an organic luminescent material, when photoexcited, transitions from the singlet ground state to the singlet excited state. In some cases, the organic luminescent material furthermore undergoes intersystem crossing from the singlet excited state to the triplet excited state. Usually, an organic luminescent material in the triplet excited state has high reactivity. Furthermore, in a case where the organic luminescent material is a luminescent material that emits no delayed fluorescence (a luminescent material other than a delayed-fluorescence material), the transition from the triplet excited state to the singlet ground state is a spin-forbidden transition, and hence, the lifetime of the organic luminescent material in the triplet excited state is long. Because of this, the organic luminescent material in the triplet excited state is prone to react with molecules therearound. In the presence of oxygen, the oxygen having high reactivity and large mobility acts as a receiver of energy from this organic luminescent material in the triplet excited state, as above-described, and causes the oxidation and deterioration of the organic luminescent material. On the other hand, in a case where no oxygen is present, molecules around the organic luminescent material can become the above-described receiver of energy. That is, in a case where no oxygen is present, and where no singlet oxygen is generated, but where an organic luminescent material in the triplet excited state, having high reactivity, is present for a long time, the reaction between this organic luminescent material and molecules therearound progresses, thus deteriorating this organic luminescent material.

Contrastingly, in a case where the organic luminescent material in the triplet excited state is a delayed-fluorescence material, the delayed-fluorescence material in the triplet excited state is rapidly converted into a delayed-fluorescence material in the singlet excited state. Because of this, the reaction between the delayed-fluorescence material in the triplet excited state and molecules therearound progresses less easily. Thus, the delayed-fluorescence material is less prone to undergo the deterioration due to this reaction, and the delayed-fluorescence material can exhibit excellent durability.

That is, because the (B) layer inhibits the invasion of oxygen into the (A) layer, the delayed-fluorescence material in the (A) layer can exhibit significantly more excellent durability than an organic luminescent material in a conventional color conversion member.

Furthermore, for the delayed-fluorescence material to be rapidly converted from the triplet excited state into the singlet excited state, it is preferable that the electron density of the electron-donor skeleton in the molecule of the delayed-fluorescence material is suitably large. For example, the HOMO level of the delayed-fluorescence material is preferably -5.7 eV or more. In this case, the effect of enhancing the durability of the delayed-fluorescence material by virtue of the (B) layer is increased. In a case where the HOMO level of the delayed-fluorescence material is -5.6 eV or more among others, the effect of enhancing the durability is more increased. In a case where the HOMO level of the delayed-fluorescence material is -5.5 eV or more, the effect of enhancing the durability is particularly increased.

The HOMO level of a compound can be calculated mathematically. In the present invention, the HOMO level is calculated by simulating the geometry optimization of the compound using the B3LYP density functional theory with the 6-31G(d) basis set and calculating a value based on the optimized geometry using the B3LYP density functional theory with the 6--311++G(d,p) basis set in a general purpose computational chemistry program "Gaussian 16" program package (produced by Gaussian, Inc.).

The (B) layer as above-described preferably contains an inorganic oxide layer or an inorganic nitride layer. Examples of a layer contained in the (B) layer include: a layer composed of an inorganic oxide, such as silicon oxide, aluminum oxide, titanium oxide, tantalum oxide, zinc oxide, tin oxide, indium oxide, yttrium oxide, or magnesium oxide; a layer composed of an inorganic nitride, such as silicon nitride, aluminum nitride, titanium nitride, or silicon carbide nitride; a metal oxide layer or metal nitride layer composed of any of these compounds and other elements; and a layer containing a resin, such as polyvinylidene chloride, an acrylic resin, a silicone-based resin, a melamine-based resin, a urethane-based resin, a fluorine-based resin, or a polyvinyl alcohol-based resin made of, for example, saponified vinyl acetate. The (B) layer may contain two or more of these. A metal oxide constituting the (B) layer is preferably silicon oxide or aluminum oxide from the viewpoint of cost. Among these, aluminum oxide can be used particular suitably. The resin constituting the (B) layer is more preferably a polyol-based resin from the viewpoint of the high oxygen barrier property. Among others, a saponified product of vinyl acetate, such as polyvinyl alcohol, an ethylene-vinyl alcohol copolymer, and a mixture containing any of these resins are still more preferable because of the particularly excellent oxygen barrier property.

In addition, the (B) layer preferably includes a cured product layer of a resin composition containing a polyol-based resin, a silicon compound having an alkoxy group, and a hydrolysate of the silicon compound. This is because forming a cross-linked structure via silicon can inhibit a polyol-based resin from swelling, for example, can maintain the high oxygen barrier property under high-temperature and high-humidity conditions. Furthermore, in a case where the (B) layer has a layered structure of a cured product layer of the resin composition and the above-described inorganic oxide layer or inorganic nitride layer, the (B) layer exhibits an even higher gas barrier property, and thus, is particularly preferable.

### <Other Layers>

If desired, a color conversion member according to the present invention may have any of such layers as below-described, for example, a base material layer, an adhesive layer, and a functional layer, besides the above-described (A) layer and (B) layer.

### (Base Material Layer)

Examples of the base material layer (for example, base material layers 10 depicted in Figs. 1 to 3) in a color conversion member according to the present invention include glass, resin films, and the like. The resin film is preferably a plastic film such as of polyethylene terephthalate (PET), polyphenylene sulfide, polycarbonate, polypropylene, polyimide, or the like. To facilitate release of the film, the surface of the base material layer may be pre-treated for mold-releasability. Similarly, to facilitate the interlaminar adhesiveness, the surface of the base material layer may be pre-treated for higher adhesiveness. The thickness of the base material layer is not specifically limited, but the lower limit of the thickness is preferably 25 µm or more and more preferably 38 µm or more. Additionally, the upper limit of the thickness is preferably 5000 µm or less, more preferably 3000 µm or less.

### (Adhesive Layer)

In a color conversion member according to the present invention, an adhesive layer may be provided, if desired, between the layers such as the (A) layer and the (B) layer. As the adhesive layer, a known material can be used without particular limitation as long as the material does not have excessive influence on the emission and durability of the color conversion member. In a case where the layers need to firmly adhere to each other, the adhesive layer that can be preferably used is a photocuring material, thermosetting material, anaerobic-curing material, or thermoplastic material. Among these, a thermosetting material is more preferable, and in particular, a thermosetting material curable at 0°C or more and 150°C or less is preferable.

### (Other Functional Layers)

A color conversion member according to the present invention may further contain a light diffusion layer, adherent layer, and/or auxiliary layer having a function such as anti-reflection function, anti-glare function, anti-reflection and anti-glare function, hard coating property (antifriction function), antistatic function, antifouling function, electromagnetic shielding function, infrared cutting function, ultraviolet cutting function, water vapor barrier function, polarization function, or color changing function, depending on the functions required.

### (Other Films)

A color conversion member according to the present invention may further include, for example, a polarized reflection film, a diffusion sheet, a prism sheet, and/or a wavelength-selective reflection film. Preferred examples of the wavelength-selective reflection film are those described in, for example, WO2017/164155 and JP2018-81250A.

### <Method of Producing Color Conversion Member>

An example of a method of producing a color conversion member according to the present invention will be described below. In this method of producing a color conversion member, a color conversion composition for producing the (A) layer is first produced as below-described.

In this method of producing a color conversion composition, the above-described delayed-fluorescence material, a binder resin, and a component(s) such as an additive, if desired, are mixed in predetermined amounts. When this is done, a solvent may be mixed, if desired.

The solvent (also referred to as a solvent medium) is not specifically limited, provided that the solvent can be used to control the viscosity of the flowable resin and does not have an excessive effect on the light emission and durability of a luminescent material. Examples of such a solvent include 2-propanol, ethyl acetate, butyl acetate, toluene, methyl ethyl ketone, methyl isobutyl ketone, hexane, acetone, terpineol, texanol, methyl cellosolve, butyl carbitol, butyl carbitol acetate, and propylene glycol monomethyl ether acetate. These solvents can be used in mixture of two or more kinds thereof. Among these solvents, ethyl acetate and toluene are particularly suitably used from the viewpoints of having no influence on the deterioration of a compound represented by the general formula (2) or the general formula (3), and having the remaining solvent in a smaller amount after drying.

The above-described components are mixed to have a predetermined composition, and then homogeneously mixed and dispersed, using a stirring and kneading machine, to obtain a color conversion composition for producing the (A) layer. Examples of the stirring and kneading machine include a homogenizer, planetary centrifugal mixer, three-roll bender, ball mill, planetary ball mill, bead mill, and the like. After or while the above components are mixed and dispersed, the resulting mixture is preferably defoamed under vacuum or reduced pressure. In addition, a specific component may be added in advance, or a treatment such as aging may be performed. The solvent can be removed with an evaporator to achieve a desired solid concentration.

Next, the color conversion composition for producing the (A) layer, obtained as above-described, is applied to an underlying material such as a base material layer or the (B) layer, and dried. In this manner, the (A) layer is formed. In a case where the binder resin contained in this color conversion composition is a thermosetting resin, this color conversion composition may be applied to an underlying material such as a base material layer, and then thermally cured to form the (A) layer. In a case where the binder resin contained in this color conversion composition is a photocuring resin, this color conversion composition may be applied to an underlying material such as a base material layer, and then photocured to form the (A) layer.

A color conversion composition for producing the (A) layer can be applied using a reverse roll coater, blade coater, comma coater, slit die coater, direct gravure coater, off-set gravure coater, kiss coater, natural roll coater, air knife coater, roll blade coater, two-stream coater, rod coater, wire bar coater, applicator, dip coater, curtain coater, spin coater, knife coater, or the like. To obtain high film-thickness uniformity, the (A) layer is preferably applied using a slit die coater, comma coater, or dip coater.

The (A) layer can be dried using a general heating device such as a hot-air dryer or an infrared dryer. In this case, the heating temperature is preferably 60 to 200°C, and the heating time is preferably 2 minutes to 4 hours. It is also possible to thermally cure the (A) layer in stages by a method such as step-curing.

In a case where the (A) layer is formed by thermal curing, the heating device is, for example, a hot-air oven or the like. The heat conditions in the thermal curing of the (A) layer can be selected depending of the binder resin. For example, the heating temperature is preferably 100°C to 300°C, and the heating time is preferably 1 minute to 2 hours.

In a case where the (A) layer is formed by photocuring, the (A) layer is preferably irradiated with high-energy light such as ultraviolet rays. The light irradiation conditions in the photocuring of the (A) layer can be selected depending of the binder resin. For example, the wavelength of the light for the irradiation is preferably 200 nm to 500 nm, and the amount of the light for the irradiation is preferably 10 mJ/cm² to 10 J/cm².

After the (A) layer is produced, it is also possible to change the base material layer, if desired. In this case, examples of a simple method include: a method in which the layers are exchanged using a hot plate; a method in which a vacuum laminator or a dry film laminator is used; and the like.

In a method of producing a color conversion member according to the present invention, the (B) layer is not specifically limited to any forming method. For example, examples of the method of forming the (B) layer include: a technique in which a resin composition for producing the (B) layer is applied to an underlying material such as a base material layer of the (A) layer, dried, and cured; a method in which a film molded by a step such as extrusion, biaxial stretching, or application or vapor deposition onto an underlying material such as a base material layer is laminated; and the like.

In addition, in a method of producing a color conversion member according to the present invention, each of the (A) layer and the (B) layer is not specifically limited to any laminating method. For example, examples of the method of laminating each of the layers include: a technique in which the (A) layer is formed on the (B) layer by coating and drying; a technique in which the (B) layer is formed on the (A) layer by coating and drying; a technique in which an independent film molded preliminarily for the (B) layer is bonded to the (A) layer; a technique in which an independent film molded preliminarily for the (A) layer is bonded to the (B) layer; a technique in which a plurality of laminate units produced separately are bonded to each other, for example, a laminate unit of "a base material layer/the (B) layer/the (A) layer" and a laminate unit of "the (B) layer/a base material" are bonded to each other; and the like. For the purpose of enhancing the stability of the laminate film, it is also preferable that necessary layers are laminated to obtain a laminate (laminate unit), and then, the laminate further undergoes a thermosetting step, aging step, and/or the like.

The thickness of a color conversion member produced in sheet shape or the like by the above-described producing method is preferably 30 µm or more and 300 µm or less. Here, the thickness of a color conversion member refers to the thickness of a combination of all the layers contained in the color conversion member, and refers to a film thickness (an average film thickness) measured by the thickness measurement method A based on mechanical scanning in JIS K7130 (1999) "Plastics - Film and sheeting - Determination of thickness". Bringing the thickness of a color conversion member according to the present invention to 30 µm or more can enhance the toughness of the color conversion member. In addition, bringing the thickness of a color conversion member according to the present invention to 300 µm or less can inhibit the color conversion member from cracking.

### <Light Source Unit>

A light source unit according to an embodiment of the present invention (hereinafter abbreviated as a light source unit according to the present invention in some cases) includes at least a light source and the above-described color conversion member. The light source included in the light source unit according to the present invention is a source which emits the excitation light described above. The installation of these light source and color conversion member is not limited to a specific way, and the light source and the color conversion member can be placed in close contact with each other, or the light source and the color conversion member can be placed away from each other, that is, in the remote phosphor configuration. In addition, a light source unit according to the present invention may further include a color filter to increase color purity.

### <Light Source>

A light source that can be used as the light source included in a light source unit according to the present invention can be of any kind as long as the light source emits light in the region of wavelengths that can be absorbed by a luminescent material in the (A) layer. For example, any light source of excitation light, such as a fluorescent light source, such as a hot cathode tube, cold cathode tube, or inorganic electroluminescence (EL), an organic EL device light source, an LED light source, an incandescent light source, or sunlight can be used in principle. Among these, an LED light source is a preferable light source. For example, a light-emitting diode having a maximum emission wavelength in the range of 400 nm or more and 500 nm or less is a more suitable LED light source. In display and lighting applications, a light-emitting diode (blue LED light source) having a maximum emission wavelength in the range of 430 nm or more and 500 nm or less is a still more preferable light source to increase the color purity of the blue light.

The light source can have one emission peak or two or more emission peaks, but excitation light with a single emission peak is preferred to increase color purity. In addition, arbitrary combinations of a plurality of light sources with different emission peaks can be used.

A light source unit according to the present invention is useful as any of various light sources such as space lighting and backlights. Specifically, a light source unit according to the present invention can be used in applications such as displays, lighting devices, interior, signs, and signboards, and is particularly suitable for use in displays and lighting devices among others.

### <Display and Lighting Device>

A display according to an embodiment of the present invention includes at least the above-described light source unit. For example, a light source unit having the above-described light source, color conversion member, and the like is used as a backlight unit in displays such as liquid crystal displays. In addition, a lighting device according to an embodiment of the present invention includes at least the above-described light source unit. For example, this lighting device is constituted so as to emit white light, wherein the configuration includes a blue LED light source in combination with a color conversion member that converts the blue light from the blue LED light source into light of a longer wavelength as a light source unit.

### Examples

The present invention will be described below by the following Examples, but the present invention is not limited to the Examples. First, the evaluation methods in Examples and Comparative Examples will be described.

### <Evaluation of Durability>

In the evaluation of durability in each of Examples and Comparative Examples, an electric current of 30 mA was passed through a luminescent device in which a color conversion member produced and a blue LED device (manufactured by USHIO EPITEX; model number SMBB450H-1100; the emission peak wavelength, 450 nm) were mounted, so that the blue LED device was lighted. The initial emission peak intensity was measured, using a spectral radiance meter (CS-1000, manufactured by Konica Minolta, Inc.). In this regard, the distance between the color conversion member and the blue LED device in this luminescent device was rendered 3 cm. Then, the color conversion member was continuously irradiated with the light from the blue LED device in a 50°C environment to evaluate the durability of the color conversion member by measuring the time required for a 5% decrease in the emission peak intensity.

### <Measurement of Oxygen Permeability>

In the measurement of oxygen permeability, a planar test piece having a uniform film thickness was used as the (B) layer (oxygen barrier layer) to be evaluated. The oxygen permeability was measured on the basis of a coulometric sensor method described in JIS K7126-2 (2006), using an oxygen permeation analyzer (model name, "OXTRAN" (registered trademark) 2/20) manufactured by Mocon (the U.S.A.) under conditions of a temperature of 20°C and a humidity of 0% RH, unless otherwise specified.

### <Measurement of Total Light Transmittance>

In the measurement of total light transmittance, a planar test piece having a uniform film thickness was used as the (B) layer (oxygen barrier layer) to be evaluated. The total light transmittance was measured in accordance with JIS K7361 (1997), using a haze meter (NDH2000) manufactured by Nippon Denshoku Industries Co., Ltd., under conditions of a temperature of 23°C and a humidity of 50% RH.

### <Luminescent Material>

In the following Examples and Comparative Examples, the compounds G-1 to G-8 were each used as a luminescent material contained in the (A) layer that was a color conversion layer. The compounds G-1 to G-8 were the compounds shown below. Among these, the compounds G-1, G-4, G-5, G-6, and G-7 were compounds that emit delayed fluorescence (delayed-fluorescence materials).

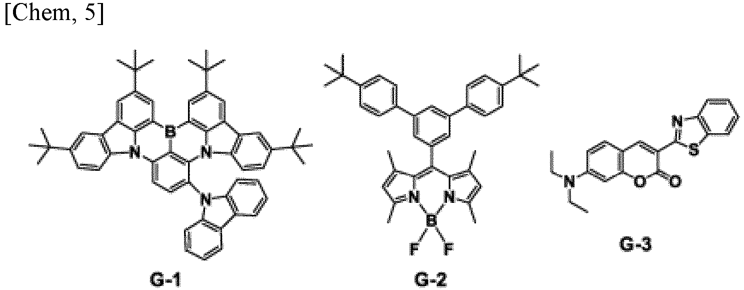

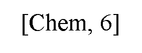

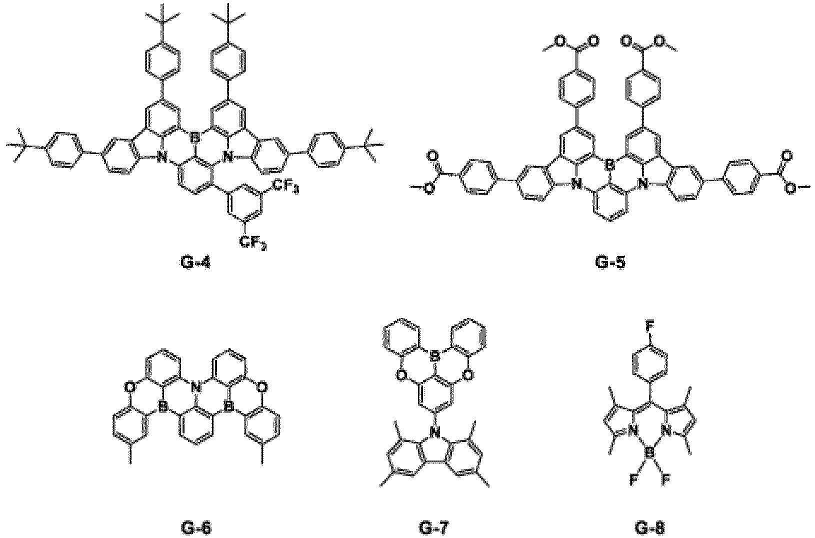

### <Resin>

In the following Examples and Comparative Examples, a polymethyl methacrylate resin "BR-85" (manufactured by Mitsubishi Chemical Corporation; the glass transition temperature, 105°C) was used as a binder resin. In addition, a polyester resin "Vylon" (registered trademark) 630 (manufactured by Toyobo Co., Ltd.) was used as a resin for an adhesive layer.

### <Scattering Material>

In the following Examples and Comparative Examples, titanium dioxide particles "JR-301" (manufactured by Tayca Co., Ltd.) were used as a scattering material.

### Example 1

In Example 1, 0.34 part by weight of the compound G-1 as a luminescent material, 3 parts by weight of titanium dioxide particles (JR-301) as a scattering material, and 300 parts by weight of ethyl acetate as a solvent were mixed with respect to 100 parts by weight of the binder resin (BR-85). The resulting mixture was then stirred and defoamed at 1000 rpm for 20 minutes using a planetary stirring and defoaming mixer "MAZERUSTAR (registered trademark) KK-400" (manufactured by Kurabo Industries Ltd.) to obtain a color conversion composition as a resin composition for producing a color conversion layer.

Next, the color conversion composition obtained as described above was applied to "Cerapeel" BLK (a release film, manufactured by Toray Advanced Film Co., Ltd.), using a slit die coater, and was dried by heating at 120°C for 20 minutes. In this manner, a color conversion layer (the (A) layer) having an average film thickness of 20 µm was formed.

Next, a thermosetting adhesive layer was formed on a polyethylene terephthalate film "Lumirror" (registered trademark) U48 (manufactured by Toray Industries, Inc.; the thickness, 50 µm) as a base material layer by a coating method. On the thermosetting adhesive layer, an ethylene-vinyl alcohol copolymer film (the ethylene content, 32 mol%; the thickness, 12 µm; the total light transmittance, 90%) as an oxygen barrier layer (the (B) layer) was laminated. In this manner, an oxygen-barrier laminated film 1 was produced. The oxygen permeability of this oxygen-barrier laminated film 1 produced using an ethylene-vinyl alcohol copolymer was approximately 0.7 cc/m²·day·atm. In Example 1, two sheets of this oxygen-barrier laminated film 1 were prepared.

Subsequently, a thermosetting adhesive layer was formed, by a coating method, on the ethylene-vinyl alcohol copolymer film side of one oxygen-barrier laminated film 1 of the above-described two oxygen-barrier laminated films 1. On the thermosetting adhesive layer, the above-described color conversion layer was laminated. Then, the "Cerapeel" BLK was peeled off from this color conversion layer.

Finally, a thermosetting adhesive layer was formed, by a coating method, on the ethylene-vinyl alcohol copolymer film side of the other oxygen-barrier laminated film 1. This thermosetting adhesive layer was laminated on the color conversion layer from which the "Cerapeel" BLK had been peeled off. In this manner, a sheet-like color conversion member constituted as illustrated in Fig. 3 was produced. In Example 1, the average film thicknesses of the thermosetting adhesive layers were all 0.50 µm. In this regard, the thermosetting adhesive layer is not illustrated in Fig. 3.

When this sheet-like color conversion member was used to convert the color of the light from the blue LED device (blue light), green light emission with high color purity was obtained, with a peak wavelength of 519 nm and a half-width of the emission spectrum at the peak wavelength of 38 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 800 hours. Example 1 exhibited the optical durability increased to approximately 53 times the optical durability in the below-described Comparative Example 1.

### Example 2

In Example 2, 0.34 part by weight of the compound G-1 as a luminescent material, 3 parts by weight of titanium dioxide particles (JR-301) as a scattering material, and 300 parts by weight of ethyl acetate as a solvent were mixed with respect to 100 parts by weight of the binder resin (BR-85). The resulting mixture was then stirred and defoamed at 1000 rpm for 20 minutes using a planetary stirring and defoaming mixer "MAZERUSTAR (registered trademark) KK-400" (manufactured by Kurabo Industries Ltd.) to obtain a color conversion composition as a resin composition for producing a color conversion layer.

Next, the color conversion composition obtained as described above was applied to "Cerapeel" BLK (a release film, manufactured by Toray Advanced Film Co., Ltd.), using a slit die coater, and was dried by heating at 120°C for 20 minutes. In this manner, a color conversion layer (the (A) layer) having an average film thickness of 20 µm was formed.

Next, a solution of a polyvinyl alcohol resin in a water/2-propanol mixture was applied, using a bar coating method, to a polyethylene terephthalate film "Lumirror" (registered trademark) U48 (manufactured by Toray Industries, Inc.; the thickness, 50 µm) as a base material layer, and then dried at 120°C for 5 minutes to form a coating layer (a polyvinyl alcohol resin layer) having an average film thickness of 0.50 µm as the (B) layer. In this manner, an oxygen-barrier laminated film 2 was produced. The total light transmittance of this polyvinyl alcohol resin layer was 91%. In addition, the oxygen permeability of the oxygen-barrier laminated film 2 produced using this polyvinyl alcohol resin layer was approximately 0.4 cc/m²·day·atm. In Example 2, two sheets of this oxygen-barrier laminated film 2 were prepared.

Subsequently, a thermosetting adhesive layer was formed, by a coating method, on the polyvinyl alcohol resin layer side of one oxygen-barrier laminated film 2 of the above-described two oxygen-barrier laminated films 2. On the thermosetting adhesive layer, the above-described color conversion layer was laminated. Then, the "Cerapeel" BLK was peeled off from this color conversion layer.

Finally, a thermosetting adhesive layer was formed, by a coating method, on the polyvinyl alcohol resin layer side of the other oxygen-barrier laminated film 2. This thermosetting adhesive layer was laminated on the color conversion layer from which the "Cerapeel" BLK had been peeled off. In this manner, a sheet-like color conversion member constituted as illustrated in Fig. 3 was produced. In Example 2, the average film thicknesses of the thermosetting adhesive layers were all 0.50 µm. In this regard, the thermosetting adhesive layer is not illustrated in Fig. 3.

When this sheet-like color conversion member was used to convert the color of the light from the blue LED device (blue light), green light emission with high color purity was obtained, with a peak wavelength of 519 nm and a half-width of the emission spectrum at the peak wavelength of 38 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 1000 hours. Example 2 exhibited the optical durability increased to approximately 67 times the optical durability in the below-described Comparative Example 1.

### Comparative Example 1

In Comparative Example 1, a color conversion composition was produced in the same manner as in Example 1, and then, this color conversion composition was applied, using a slit die coater, to a polyethylene terephthalate film "Lumirror" (registered trademark) U48 (manufactured by Toray Industries, Inc.; the thickness, 50 µm; the oxygen permeability, approximately 40 cc/m²·day·atm; the total light transmittance, 89%) as a base material layer, and dried by heating at 120°C for 20 minutes. In this manner, a color conversion layer (the (A) layer) having an average film thickness of 20 µm was formed.

Next, a thermosetting adhesive layer was formed on another polyethylene terephthalate film "Lumirror" (registered trademark) U48 by a coating method. This thermosetting adhesive layer was laminated on the color conversion layer in Comparative Example 1. In this manner, a sheet-like color conversion member constituted by a color conversion layer sandwiched between two polyethylene terephthalate films was produced. This sheet-like color conversion member does not have the (B) layer.

When this sheet-like color conversion member was used to convert the color of the light from the blue LED device (blue light), green light emission with high color purity was obtained, with a peak wavelength of 519 nm and a half-width of the emission spectrum at the peak wavelength of 38 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 15 hours.

### Comparative Example 2

In Comparative Example 2, a sheet-like color conversion member was produced and evaluated in the same manner as in Example 1 except that 0.20 part by weight of the compound G-2 was used as a luminescent material (organic luminescent material) for a color conversion layer. When this sheet-like color conversion member was used to convert the color of the light from the blue LED device (blue light), green light emission with high color purity was obtained, with a peak wavelength of 526 nm and a half-width of the emission spectrum at the peak wavelength of 29 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 500 hours. The optical durability of the sheet-like color conversion member in Comparative Example 2 was approximately 0.47 times the optical durability in Example 1.

### Comparative Example 3

In Comparative Example 3, a sheet-like color conversion member was produced and evaluated in the same manner as in Comparative Example 1 except that 0.20 part by weight of the compound G-2 was used as a luminescent material (organic luminescent material) for a color conversion layer. When this sheet-like color conversion member was used to convert the color of the light from the blue LED device (blue light), green light emission with high color purity was obtained, with a peak wavelength of 526 nm and a half-width of the emission spectrum at the peak wavelength of 29 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 20 hours.

### Comparative Example 4

In Comparative Example 4, a sheet-like color conversion member was produced and evaluated in the same manner as in Example 1 except that 0.20 part by weight of the compound G-3 was used as a luminescent material (organic luminescent material) for a color conversion layer. When this sheet-like color conversion member was used to convert the color of the light from the blue LED device (blue light), green light emission was obtained, with a peak wavelength of 490 nm and a half-width of the emission spectrum at the peak wavelength of 55 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 300 hours. The optical durability of the sheet-like color conversion member in Comparative Example 4 was approximately 0.23 times the optical durability in Example 1.

### Comparative Example 5

In Comparative Example 5, a sheet-like color conversion member was produced and evaluated in the same manner as in Comparative Example 1 except that 0.20 part by weight of the compound G-3 was used as a luminescent material (organic luminescent material) for a color conversion layer. When this sheet-like color conversion member was used to convert the color of the light from the blue LED device (blue light), green light emission was obtained, with a peak wavelength of 490 nm and a half-width of the emission spectrum at the peak wavelength of 55 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 25 hours.

### Example 3

In Example 3, 0.34 part by weight of the compound G-1 as a luminescent material, 3 parts by weight of titanium dioxide particles (JR-301) as a scattering material, and 300 parts by weight of ethyl acetate as a solvent were mixed with respect to 100 parts by weight of the binder resin (BR-85). The resulting mixture was then stirred and defoamed at 1000 rpm for 20 minutes using a planetary stirring and defoaming mixer "MAZERUSTAR (registered trademark) KK-400" (manufactured by Kurabo Industries Ltd.) to obtain a color conversion composition as a resin composition for producing a color conversion layer.

Next, the color conversion composition obtained as described above was applied to "Cerapeel" BLK (a release film, manufactured by Toray Advanced Film Co., Ltd.), using a slit die coater, and was dried by heating at 120°C for 20 minutes. In this manner, a color conversion layer (the (A) layer) having an average film thickness of 20 µm was formed.

Next, tetraethyl orthosilicate (1.2 g), 2-propanol (0.5 g), and methanol (0.5 g) were mixed, and then, to this mixture, an aqueous hydrochloric acid solution mixture of 0.1 N hydrochloric acid (4 g) and water (5 g) was gradually added dropwise. Then, a polyvinyl alcohol resin (0.4 g) having a degree of saponification of 98 mol% or more was mixed, as a polyol-based resin, with the mixture resulting from the above-described dropwise addition of the aqueous hydrochloric acid solution, and the resulting mixture was stirred. In this manner, a (B) layer resin liquid was obtained.

Next, the (B) layer resin liquid obtained as above-described was applied, using a bar coating method, to an alumina-deposited polyethylene terephthalate film "Barrialox" (registered trademark) 1011HG (manufactured by Toray Industries, Inc.; the thickness, 12 µm), and then dried at 150°C for 1 minutes to form a coating layer having an average film thickness of 1 µm as the (B) layer. In this manner, an oxygen-barrier laminated film 3 was produced. The oxygen permeability of this oxygen-barrier laminated film 3 was approximately 0.2 cc/m²·day·atm. In addition, the total light transmittance of this coating layer was 89%.

Then, using this oxygen-barrier laminated film 3, a sheet-like color conversion member constituted as illustrated in Fig. 3 was produced and evaluated in the same manner as in Example 2. When this sheet-like color conversion member was used to convert the color of the light from the blue LED device (blue light), green light emission with high color purity was obtained, with a peak wavelength of 519 nm and a half-width of the emission spectrum at the peak wavelength of 38 nm, but this is an excerpt of the result focusing only on the green light region. Moreover, when the color conversion member was continuously irradiated with the light from the blue LED device in a 50°C environment, the time (optical durability) required for a 5% decrease in the emission peak intensity was 1200 hours. Example 3 exhibited the optical durability increased to approximately 80 times the optical durability in the above-described Comparative Example 1.

### Examples 4 to 7

In Examples 4 to 7, a sheet-like color conversion member was produced and evaluated in the same manner as in Example 2 except that the compounds G-4 to G-7 were respectively used as a luminescent material (organic luminescent material) for a color conversion layer, and mixed in so as to be adjusted to the same amount of substance as the compound G-1 in Example 2.

### Comparative Examples 6 to 9

In Comparative Examples 6 to 9, a sheet-like color conversion member was produced and evaluated in the same manner as in Comparative Example 1 except that the compounds G-4 to G-8 were respectively used as a luminescent material (organic luminescent material) for a color conversion layer, mixed in so as to be adjusted to the same amount of substance as the compound G-1 in Comparative Example 1.

### Comparative Example 10

In Comparative Examples 10, a sheet-like color conversion member was produced and evaluated in the same manner as in Comparative Example 2 except that the compound G-8 was used as a luminescent material (organic luminescent material) for a color conversion layer, and mixed in so as to be adjusted to the same amount of substance as the compound G-2 in Comparative Example 2.

### Comparative Example 11

In Comparative Examples 11, a sheet-like color conversion member was produced and evaluated in the same manner as in Comparative Example 3 except that the compound G-8 was used as a luminescent material (organic luminescent material) for a color conversion layer, and mixed in so as to be adjusted to the same amount of substance as the compound G-2 in Comparative Example 3.

The constitution and evaluation results of the sheet-like color conversion member in each of Examples 1 to 7 and Comparative Examples 1 to 11 are as shown in Table 1.

**[Table 1]**

| | (A) Layer Luminescent Material | HOMO Level (ev) | (B) Layer Oxygen Barrier Layer | Oxygen Permeability (20°C, 0% RH) | Peak Wavelength (nm) | Half-width (nm) | Optical Durability (h) |
|---|---|---|---|---|---|---|---|
| | | | | (cc/m²·day·atm) | | | |
| Example 1 | G-1 | -5.4 | Oxygen-barrier Laminated Film 1 | 0.7 | 519 | 38 | 800 |
| Example 2 | G-1 | -5.4 | Oxygen-barrier Laminated Film 2 | 0.4 | 519 | 38 | 1000 |
| Example 3 | G-1 | -5.4 | Oxygen-barrier Laminated Film 3 | 0.2 | 519 | 38 | 1200 |
| Example 4 | G-4 | -5.6 | Oxygen-barrier Laminated Film 2 | 0.4 | 516 | 38 | 1300 |
| Example 5 | G-5 | -5.8 | Oxygen-barrier Laminated Film 2 | 0.4 | 518 | 30 | 1200 |
| Example 6 | G-6 | -5.5 | Oxygen-barrier Laminated Film 2 | 0.4 | 520 | 30 | 700 |
| Example 7 | G-7 | -5.3 | Oxygen-barrier Laminated Film 2 | 0.4 | 460 | 80 | 600 |
| Comparative Example 1 | G-1 | -5.4 | none | 40 | 519 | 38 | 15 |
| Comparative Example 2 | G-2 | -5.7 | Oxygen-barrier Laminated Film 1 | 0.7 | 526 | 29 | 500 |
| Comparative Example 3 | G-2 | -5.7 | none | 40 | 526 | 29 | 20 |
| Comparative Example 4 | G-3 | -5.6 | Oxygen-barrier Laminated Film 1 | 0.7 | 490 | 55 | 300 |
| Comparative Example 5 | G-3 | -5.6 | none | 40 | 490 | 55 | 25 |
| Comparative Example 6 | G-4 | -5.6 | none | 40 | 516 | 38 | 25 |
| Comparative Example 7 | G-5 | -5.8 | none | 40 | 518 | 30 | 40 |
| Comparative Example 8 | G-6 | -5.5 | none | 40 | 520 | 30 | 15 |
| Comparative Example 9 | G-7 | -5.3 | none | 40 | 460 | 80 | 15 |
| Comparative Example 10 | G-8 | -5.9 | Oxygen-barrier Laminated Film 1 | 0.7 | 526 | 29 | 600 |
| Comparative Example 11 | G-8 | -5.9 | none | 40 | 526 | 29 | 25 |

As shown in Table 1, in a case where the (A) layer containing the compound G-1, which was an organic luminescent material that emits delayed fluorescence, was used in combination with the (B) layer having an oxygen barrier property, the combination had a very noticeable effect for enhancing the optical durability, as obvious from the comparison between Examples 1, 2, and 3 and Comparative Example 1.

Additionally, as shown in Table 1, in a case where the (A) layer containing the compound G-2 or the compound G-3, which was not an organic luminescent material that emits delayed fluorescence, was used in combination with the (B) layer having an oxygen barrier property, the combination had higher optical durability undoubtedly, compared with the nonuse of the (B) layer having an oxygen barrier property, as obvious from the comparison between Comparative Example 2 and Comparative Example 3 and the comparison between Comparative Example 4 and Comparative Example 5. However, the enhancement of the optical durability in this case was not as large as the enhancement in the case where the (A) layer was used, in which the (A) layer contained the compound G-1 as an organic luminescent material that emits delayed fluorescence.

The above-described results have revealed that, in a case where the (A) layer containing the compound G-1 as an organic luminescent material that emits delayed fluorescence was used in combination with the (B) layer having an oxygen barrier property, the effect of enhancing the optical durability was very noticeable, significantly exceeding an effect expected from a conventional technology.

As shown in Table 1, this excellent effect of enhancing the optical durability was verified also with the compounds G-4 to G-7 that were delayed-fluorescence materials other than the compound G-1. Furthermore, the comparison between Example 4 and Comparative Example 6 and the comparison between Example 5 and Comparative Example 7 have revealed that, in a case where the compound G-4 having a HOMO level of -5.6 eV was used, the effect of enhancing the optical durability was approximately 52 times as high, and in contrast, that in a case where the compound G-5 having a HOMO level of -5.8 eV was used, the effect of enhancing the optical durability was approximately 30 times as high. These results of comparison have revealed that, in a case where the compound G-4 having a HOMO level of -5.7 eV or more was used, a larger effect was exhibited in terms of enhancing the optical durability. On the other hand, the comparison between Comparative Example 2 and Comparative Example 3 and the comparison between Comparative Example 10 and Comparative Example 11 have revealed that, in a case where the compound G-2 that was not a delayed-fluorescence material was used, such a difference in the effect as depended on the HOMO level was not observed. That is, it is understood that this difference in the effect is characteristically found in the present invention.

### Industrial Applicability

As above-described, a color conversion member, a light source unit containing the same, a display, and a lighting device according to the present invention are suitable for achieving both improved color reproducibility and increased durability.

### Reference Signs List

- 1A, 1B, 1C: Color conversion member
- 10: Base material layer
- 11: (A) layer
- 12: (B) layer

## Claims

1. A color conversion member that converts incident light into light of a wavelength different from the wavelength of the incident light,
the color conversion member comprising at least the following (A) layer and (B) layer;
wherein the (A) layer is a color conversion layer containing:
at least one organic luminescent material that emits delayed fluorescence; and
a binder resin; and
wherein the (B) layer is a layer having an oxygen permeability of 1.0 cc/(m²·day·atm) or less.

2. The color conversion member according to claim 1, wherein the (A) layer and the (B) layers are layered in the order, the (B) layer/the (A) layer/the (B) layer.

3. The color conversion member according to claim 1 or 2, wherein the oxygen permeability of the (B) layer is 0.5 cc/(m²·day·atm) or less.

4. The color conversion member according to any one of claims 1 to 3, wherein the organic luminescent material is a compound containing a substructure represented by the following general formula (1): 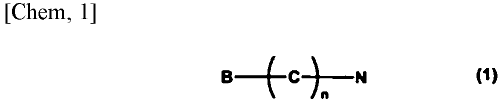 (wherein, in the general formula (1), B is a boron atom, N is a nitrogen atom, and C is a carbon atom; n is an integer of 0 or larger and 2 or smaller; and in a case where n is 0, the substructure represented by the general formula (1) represents a direct-bond structure between B and N.)

5. The color conversion member according to claim 4, wherein the organic luminescent material is a compound containing two or more substructures represented by the general formula (1).

6. The color conversion member according to any one of claims 1 to 4, wherein the organic luminescent material comprises a compound represented by the following general formula (2) or general formula (3): 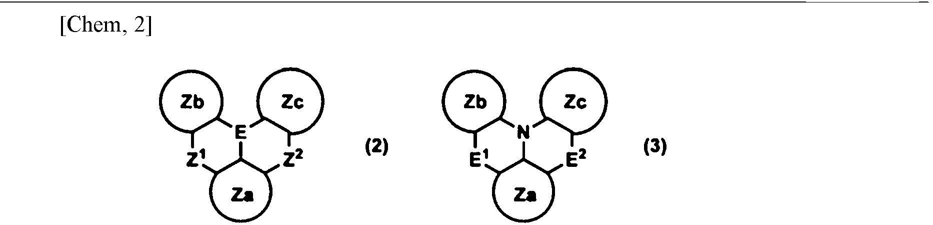 (wherein, in the general formula (2) or the general formula (3), the ring Za, the ring Zb, and the ring Zc independently represent a substituted or unsubstituted aryl ring having 6 to 30 ring-forming carbon atoms or a substituted or unsubstituted heteroaryl ring having 6 to 30 ring-forming carbon atoms; Z¹ and Z² are each independently an oxygen atom, NRa (a nitrogen atom bearing an Ra substituent), or a sulfur atom; in a case where Z¹ is NRa, the substituent Ra, together with the ring Za or the ring Zb, optionally forms a ring; in a case where Z² is NRa, the substituent Ra, together with the ring Za or the ring Zc, optionally forms a ring; E is a boron atom, a phosphorus atom, SiRa (a silicon atom bearing an Ra substituent), or P=O; E¹ and E² are independently BRa (a boron atom bearing an Ra substituent), PRa (a phosphorus atom bearing an Ra substituent), SiRa₂ (a silicon atom bearing two Ra substituents), P(=O)Ra₂ (a phosphine oxide bearing two Ra substituents) or P(=S)Ra₂ (a phosphine sulfide bearing two Ra substituents), or S(=O) or S(=O)₂; in a case where E¹ is BRa, PRa, SiRa₂, P(=O)Ra₂, or P(=S)Ra₂, the substituent Ra, together with the ring Za or the ring Zb, optionally forms a ring; in a case where E² is BRa, PRa, SiRa₂, P(=O)Ra₂, or P(=S)Ra₂, the substituent Ra, together with the ring Za or the ring Zc, optionally forms a ring; the substituents Ra are each independently a substituent selected from hydrogen, substituted or unsubstituted alkyl, substituted or unsubstituted cycloalkyl, substituted or unsubstituted heterocycle, substituted or unsubstituted alkenyl, substituted or unsubstituted cycloalkenyl, substituted or unsubstituted alkynyl, substituted or unsubstituted aryl, substituted or unsubstituted heteroaryl, hydroxyl, thiol, substituted or unsubstituted alkoxy, substituted or unsubstituted alkylthio, substituted or unsubstituted aryl ether, substituted or unsubstituted arylthioether, halogen, cyano, aldehyde, substituted or unsubstituted carbonyl, substituted or unsubstituted carboxyl, substituted or unsubstituted oxycarbonyl, substituted or unsubstituted ester, substituted or unsubstituted carbamoyl, substituted or unsubstituted amide, sulfonyl, substituted or unsubstituted sulfonic acid ester, substituted or unsubstituted sulfonamide, substituted or unsubstituted amino, substituted or unsubstituted imino, nitro, substituted or unsubstituted silyl, substituted or unsubstituted siloxanyl, substituted or unsubstituted boryl, substituted or unsubstituted phosphine oxide, and a condensed ring and an aliphatic ring that are each formed adjacently to a substituent; and in addition, the substituent Ra may be further substituted with a substituent selected from these.)

7. The color conversion member according to claim 6, wherein E in the general formula (2) is a boron atom, and E¹ and E² in the general formula (3) are BRa.

8. The color conversion member according to any one of claims 1 to 7, wherein the organic luminescent material is observed to emit light having a peak wavelength in the range of 500 nm or more and less than 580 nm, when irradiated with excitation light having a wavelength in the range of 400 nm or more and 500 nm or less.

9. The color conversion member according to any one of claims 1 to 8, wherein the HOMO level of the organic luminescent material is -5.7 eV or more.

10. The color conversion member according to any one of claims 1 to 9, wherein the (B) layer comprises an inorganic oxide layer or an inorganic nitride layer.

11. The color conversion member according to any one of claims 1 to 10, wherein the (B) layer comprises a cured product layer of a resin composition containing a polyol-based resin, a silicon compound having an alkoxy group, and a hydrolysate of the silicon compound.

12. A light source unit comprising: a light source; and the color conversion member according to any one of claims 1 to 11.

13. The light source unit according to claim 12, wherein the light source is a light-emitting diode with a maximum emission wavelength in the range of 430 nm or more and 500 nm or less.

14. A display comprising the light source unit according to claim 12 or 13.

15. A lighting device comprising the light source unit according to claim 12 or 13.

## Patentansprüche

1. Farbumwandlungselement, das einfallendes Licht in Licht mit einer Wellenlänge umwandelt, die sich von der Wellenlänge des einfallenden Lichts unterscheidet,
wobei das Farbumwandlungselement mindestens die folgende (A) Schicht und (B) Schicht umfasst;
wobei die (A) Schicht eine Farbumwandlungsschicht ist, die enthält:
mindestens ein organisches lumineszierendes Material, das verzögerte Fluoreszenz emittiert; und
ein Bindemittelharz; und
wobei die (B) Schicht eine Schicht mit einer Sauerstoffdurchlässigkeit von 1,0 cc/(m² · Tag · atm) oder weniger ist.

2. Farbumwandlungselement nach Anspruch 1, wobei die (A) Schicht und die (B) Schicht in der Reihenfolge (B) Schicht/(A) Schicht/(B) Schicht geschichtet sind.

3. Farbumwandlungselement nach Anspruch 1 oder 2, wobei die Sauerstoffdurchlässigkeit der (B) Schicht 0,5 cc/(m² · Tag · atm) oder weniger ist.

4. Farbumwandlungselement nach einem der Ansprüche 1 bis 3, wobei das organische lumineszierende Material eine Verbindung ist, die eine durch die folgende allgemeine Formel (1) dargestellte Substruktur enthält: 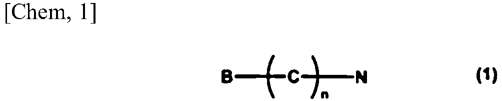 (wobei in der allgemeinen Formel (1) B ein Boratom ist, N ein Stickstoffatom ist und C ein Kohlenstoffatom ist; n eine ganze Zahl von 0 oder größer und 2 oder kleiner ist; und in einem Fall, in dem n 0 ist, die durch die allgemeine Formel (1) dargestellte Substruktur eine Direktbindungsstruktur zwischen B und N darstellt).

5. Farbumwandlungselement nach Anspruch 4, wobei das organische lumineszierende Material eine Verbindung ist, die zwei oder mehr durch die allgemeine Formel (1) dargestellte Substrukturen enthält.

6. Farbumwandlungselement nach einem der Ansprüche 1 bis 4, wobei das organische lumineszierende Material eine durch die folgende allgemeine Formel (2) oder allgemeine Formel (3) dargestellte Verbindung umfasst: 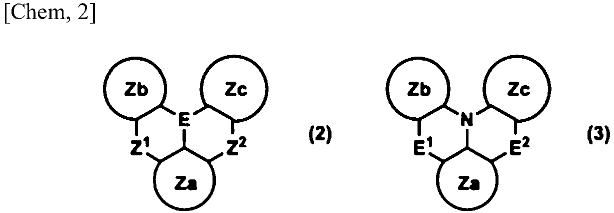 (wobei in der allgemeinen Formel (2) oder der allgemeinen Formel (3) der Ring Za, der Ring Zb und der Ring Zc unabhängig einen substituierten oder unsubstituierten Arylring mit 6 bis 30 ringbildenden Kohlenstoffatomen oder einen substituierten oder unsubstituierten Heteroarylring mit 6 bis 30 ringbildenden Kohlenstoffatomen darstellen; Z¹ und Z² jeweils unabhängig ein Sauerstoffatom, NRa (ein Stickstoffatom, das einen Ra-Substituenten trägt) oder ein Schwefelatom sind; in einem Fall, in dem Z¹ NRa ist, der Substituent Ra zusammen mit dem Ring Za oder dem Ring Zb gegebenenfalls einen Ring bildet; in einem Fall, in dem Z² NRa ist, der Substituent Ra zusammen mit dem Ring Za oder dem Ring Zc gegebenenfalls einen Ring bildet; E ein Boratom, ein Phosphoratom, SiRa (ein Siliciumatom, das einen Ra-Substituenten trägt) oder P=O ist; E¹ und E² unabhängig BRa (ein Boratom, das einen Ra-Substituenten trägt), PRa (ein Phosphoratom, das einen Ra-Substituenten trägt), SiRa₂ (ein Siliciumatom, das zwei Ra-Substituenten trägt), P(=O)Ra₂ (ein Phosphinoxid, das zwei Ra-Substituenten trägt) oder P(=S)Ra₂ (ein Phosphinsulfid, das zwei Ra-Substituenten trägt) oder S(=O) oder S(=O)₂ sind; in einem Fall, in dem E¹ BRa, PRa, SiRa₂, P(=O)Ra₂ oder P(=S)Ra₂ ist, der Substituent Ra zusammen mit dem Ring Za oder dem Ring Zb gegebenenfalls einen Ring bildet; in einem Fall, in dem E² BRa, PRa, SiRa₂, P(=O)Ra₂ oder P(=S)Ra₂ ist, der Substituent Ra zusammen mit dem Ring Za oder dem Ring Zc gegebenenfalls einen Ring bildet; die Substituenten Ra jeweils unabhängig ein Substituent sind, der aus Wasserstoff, substituiertem oder unsubstituiertem Alkyl, substituiertem oder unsubstituiertem Cycloalkyl, substituiertem oder unsubstituiertem Heterocyclus, substituiertem oder unsubstituiertem Alkenyl, substituiertem oder unsubstituiertem Cycloalkenyl, substituiertem oder unsubstituiertem Alkinyl, substituiertem oder unsubstituiertem Aryl, substituiertem oder unsubstituiertem Heteroaryl, Hydroxyl, Thiol, substituiertem oder unsubstituiertem Alkoxy, substituiertem oder unsubstituiertem Alkylthio, substituiertem oder unsubstituiertem Arylether, substituiertem oder unsubstituiertem Arylthioether, Halogen, Cyano, Aldehyd, substituiertem oder unsubstituiertem Carbonyl, substituiertem oder unsubstituiertem Carboxyl, substituiertem oder unsubstituiertem Oxycarbonyl, substituiertem oder unsubstituiertem Ester, substituiertem oder unsubstituiertem Carbamoyl, substituiertem oder unsubstituiertem Amid, Sulfonyl, substituiertem oder unsubstituiertem Sulfonsäureester, substituiertem oder unsubstituiertem Sulfonamid, substituiertem oder unsubstituiertem Amino, substituiertem oder unsubstituiertem Imino, Nitro, substituiertem oder unsubstituiertem Silyl, substituiertem oder unsubstituiertem Siloxanyl, substituiertem oder unsubstituiertem Boryl, substituiertem oder unsubstituiertem Phosphinoxid und einem kondensierten Ring und einem aliphatischen Ring, die jeweils benachbart zu einem Substituenten gebildet sind, ausgewählt ist; und zusätzlich der Substituent Ra ferner mit einem aus diesen ausgewählten Substituenten substituiert sein kann).

7. Farbumwandlungselement nach Anspruch 6, wobei E in der allgemeinen Formel (2) ein Boratom ist und E¹ und E² in der allgemeinen Formel (3) BRa sind.

8. Farbumwandlungselement nach einem der Ansprüche 1 bis 7, wobei beobachtet wird, dass das organische lumineszierende Material Licht mit einer Spitzenwellenlänge im Bereich von 500 nm oder mehr und weniger als 580 nm emittiert, wenn es mit Anregungslicht mit einer Wellenlänge im Bereich von 400 nm oder mehr und 500 nm oder weniger bestrahlt wird.

9. Farbumwandlungselement nach einem der Ansprüche 1 bis 8, wobei das HOMO-Niveau des organischen lumineszierenden Materials -5,7 eV oder mehr beträgt.

10. Farbumwandlungselement nach einem der Ansprüche 1 bis 9, wobei die (B) Schicht eine anorganische Oxidschicht oder eine anorganische Nitridschicht umfasst.

11. Farbumwandlungselement nach einem der Ansprüche 1 bis 10, wobei die (B) Schicht eine gehärtete Produktschicht einer Harzzusammensetzung umfasst, die ein Harz auf Polyolbasis, eine Siliciumverbindung mit einer Alkoxygruppe und ein Hydrolysat der Siliciumverbindung enthält.

12. Lichtquelleneinheit, umfassend: eine Lichtquelle; und das Farbumwandlungselement nach einem der Ansprüche 1 bis 11.

13. Lichtquelleneinheit nach Anspruch 12, wobei die Lichtquelle eine Leuchtdiode mit einer maximalen Emissionswellenlänge im Bereich von 430 nm oder mehr und 500 nm oder weniger ist.

14. Anzeige, umfassend die Lichtquelleneinheit nach Anspruch 12 oder 13.

15. Beleuchtungsvorrichtung, umfassend die Lichtquelleneinheit nach Anspruch 12 oder 13.

## Revendications

1. Elément de conversion de couleur qui convertit une lumière incidente en une lumière d'une longueur d'onde différente de la longueur d'onde de la lumière incidente,
l'élément de conversion de couleur comprenant au moins la couche (A) et la couche (B) suivantes ;
dans lequel la couche (A) est une couche de conversion de couleur contenant :
au moins un matériau luminescent organique qui émet une fluorescence retardée ; et
une résine liante ; et
dans lequel la couche (B) est une couche ayant une perméabilité à l'oxygène de 1,0 cc/(m²·jour·atm) ou moins.

2. Elément de conversion de couleur selon la revendication 1, dans lequel la couche (A) et la couche (B) sont stratifiées dans l'ordre couche (B)/couche (A)/couche (B).

3. Elément de conversion de couleur selon la revendication 1 ou 2, dans lequel la perméabilité à l'oxygène de la couche (B) est de 0,5 cc/(m²·jour·atm) ou moins.

4. Elément de conversion de couleur selon l'une quelconque des revendications 1 à 3, dans lequel le matériau luminescent organique est un composé contenant une sous-structure représentée par la formule générale (1) suivante : 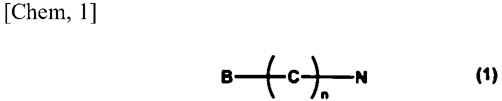 (dans lequel, dans la formule générale (1), B est un atome de bore, N est un atome d'azote, et C est un atome de carbone ; n est un entier de 0 ou plus et de 2 ou moins ; et dans un cas où n est 0, la sous-structure représentée par la formule générale (1) représente une structure de liaison directe entre B et N).

5. Elément de conversion de couleur selon la revendication 4, dans lequel le matériau luminescent organique est un composé contenant deux sous-structures ou plus représentées par la formule générale (1).

6. Elément de conversion de couleur selon l'une quelconque des revendications 1 à 4, dans lequel le matériau luminescent organique comprend un composé représenté par la formule générale (2) ou la formule générale (3) suivante : 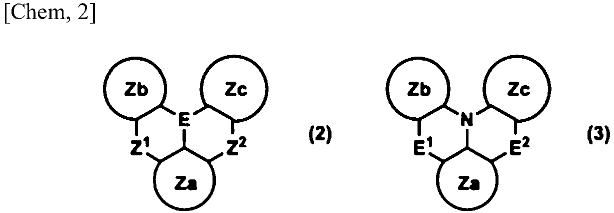 (dans lequel, dans la formule générale (2) ou la formule générale (3), le cycle Za, le cycle Zb, et le cycle Zc représentent indépendamment un cycle aryle substitué ou non substitué ayant 6 à 30 atomes de carbone formant un cycle ou un cycle hétéroaryle substitué ou non substitué ayant 6 à 30 atomes de carbone formant un cycle ; Z¹ et Z² sont chacun indépendamment un atome d'oxygène, NRa (un atome d'azote portant un substituant Ra), ou un atome de soufre ; dans un cas où Z¹ est NRa, le substituant Ra, conjointement avec le cycle Za ou le cycle Zb, forme éventuellement un cycle ; dans un cas où Z² est NRa, le substituant Ra, conjointement avec le cycle Za ou le cycle Zc, forme éventuellement un cycle ; E est un atome de bore, un atome de phosphore, SiRa (un atome de silicium portant un substituant Ra), ou P=O ; E¹ et E² sont indépendamment BRa (un atome de bore portant un substituant Ra), PRa (un atome de phosphore portant un substituant Ra), SiRa₂ (un atome de silicium portant deux substituants Ra), P(=O)Ra₂ (un oxyde de phosphine portant deux substituants Ra) ou P(=S)Ra₂ (un sulfure de phosphine portant deux substituants Ra), ou S(=O) ou S(=O)₂ ; dans un cas où E¹ est BRa, PRa, SiRa₂, P(=O)Ra₂, ou P(=S)Ra₂, le substituant Ra, conjointement avec le cycle Za ou le cycle Zb, forme éventuellement un cycle ; dans un cas où E² est BRa, PRa, SiRa₂, P(=O)Ra₂, ou P(=S)Ra₂, le substituant Ra, conjointement avec le cycle Za ou le cycle Zc, forme éventuellement un cycle ; les substituants Ra sont chacun indépendamment un substituant choisi parmi un hydrogène, un alkyle substitué ou non substitué, un cycloalkyle substitué ou non substitué, un hétérocycle substitué ou non substitué, un alcényle substitué ou non substitué, un cycloalcényle substitué ou non substitué, un alcynyle substitué ou non substitué, un aryle substitué ou non substitué, un hétéroaryle substitué ou non substitué, un hydroxyle, un thiol, un alcoxy substitué ou non substitué, un alkylthio substitué ou non substitué, un aryléther substitué ou non substitué, un arylthioéther substitué ou non substitué, un halogène, un cyano, un aldéhyde, un carbonyle substitué ou non substitué, un carboxyle substitué ou non substitué, un oxycarbonyle substitué ou non substitué, un ester substitué ou non substitué, un carbamoyle substitué ou non substitué, un amide substitué ou non substitué, un sulfonyle, un ester d'acide sulfonique substitué ou non substitué, un sulfonamide substitué ou non substitué, un amino substitué ou non substitué, un imino substitué ou non substitué, un nitro, un silyle substitué ou non substitué, un siloxanyle substitué ou non substitué, un boryle substitué ou non substitué, un oxyde de phosphine substitué ou non substitué, et un cycle condensé et un cycle aliphatique qui sont chacun formés de manière adjacente à un substituant ; et en outre, le substituant Ra peut être en outre substitué par un substituant choisi parmi ceux-ci).

7. Elément de conversion de couleur selon la revendication 6, dans lequel E dans la formule générale (2) est un atome de bore, et E¹ et E² dans la formule générale (3) sont BRa.

8. Elément de conversion de couleur selon l'une quelconque des revendications 1 à 7, dans lequel le matériau luminescent organique est observé pour émettre une lumière ayant une longueur d'onde de crête dans la plage de 500 nm ou plus et inférieure à 580 nm, lorsqu'il est irradié avec une lumière d'excitation ayant une longueur d'onde dans la plage de 400 nm ou plus et 500 nm ou moins.

9. Elément de conversion de couleur selon l'une quelconque des revendications 1 à 8, dans lequel le niveau HOMO du matériau luminescent organique est de -5,7 eV ou plus.

10. Elément de conversion de couleur selon l'une quelconque des revendications 1 à 9, dans lequel la couche (B) comprend une couche d'oxyde inorganique ou une couche de nitrure inorganique.

11. Elément de conversion de couleur selon l'une quelconque des revendications 1 à 10, dans lequel la couche (B) comprend une couche de produit durci d'une composition de résine contenant une résine à base de polyol, un composé de silicium ayant un groupe alcoxy, et un hydrolysat du composé de silicium.

12. Unité de source de lumière comprenant : une source de lumière ; et l'élément de conversion de couleur selon l'une quelconque des revendications 1 à 11.

13. Unité de source de lumière selon la revendication 12, dans laquelle la source de lumière est une diode électroluminescente avec une longueur d'onde d'émission maximale dans la plage de 430 nm ou plus et 500 nm ou moins.

14. Affichage comprenant l'unité de source de lumière selon la revendication 12 ou 13.

15. Dispositif d'éclairage comprenant l'unité de source de lumière selon la revendication 12 ou 13.
